# EUROPEAN PATENT APPLICATION

(11) **EP 4 546 428 A1**
(43) Date of publication of application: **30.04.2025**
(21) Application number: 22951234.8
(22) Date of filing: 15.07.2022
(51) Int. Cl.: H01L 27/15, H01L 27/12, H01L 25/075, H01L 33/32, H01L 33/62

(54) **SEMICONDUCTOR LIGHT-EMITTING ELEMENT PACKAGE AND DISPLAY DEVICE**

(71) Applicant: LG Electronics Inc., Yeongdeungpo-gu Seoul 07336 (KR)
(72) Inventor: KIM, Myoungsoo, Seoul 06772 (KR); PARK, Sungjin, Seoul 06772 (KR); OH, Taesu, Seoul 06772 (KR); KANG, Byungjun, Seoul 06772 (KR); KIM, Jungsub, Seoul 06772 (KR)
(74) Representative: Vossius & Partner Patentanwälte Rechtsanwälte mbB
(86) International application number: PCT/KR2022/010341
(87) International publication number: WO 2024/014579

(57) **Abstract**

A semiconductor light-emitting element package may include a common connection electrode having a first region and a second region, a first semiconductor light-emitting element on the first region of the common connection electrode, a pair of assembling wirings on the second region of the common connection electrode, and a second semiconductor light-emitting element on the pair of assembling wirings.

## Description

### [Technical Field]

The embodiment relates to a semiconductor light-emitting element package and a display device.

### [Background Art]

A large-area display includes a liquid crystal display (LCD), an OLED display, and a micro-LED display.

A micro-LED display is a display that uses micro-LEDs, which are semiconductor light-emitting elements with a diameter or cross-sectional area of 100µm or less, as display elements.

Since a micro-LED display uses micro-LEDs, which are semiconductor light-emitting elements, as display elements, it has excellent performance in many characteristics such as contrast ratio, response speed, color reproducibility, viewing angle, brightness, resolution, lifespan, luminous efficiency, and luminance.

In particular, a micro-LED display has the advantage of being able to freely adjust the size or resolution by separating and combining the screen in a modular manner, and the advantage of being able to implement a flexible display.

However, since a large micro-LED display requires millions or more micro-LEDs, there is a technical problem in quickly and accurately transferring micro-LEDs to the display panel.

Recently developed transfer technologies include the pick and place process, the laser lift-off method, and the self-assembly method.

Among these, the self-assembly method is a method in which semiconductor light-emitting elements find their assembly positions within a fluid, which is advantageous for implementing a large-screen display device.

However, research on the technology for manufacturing display through self-assembly of micro-LEDs is still insufficient.

In particular, in the case of rapidly transferring millions or more semiconductor light-emitting elements to a large display in the conventional technology, the transfer speed can be improved, but the transfer error rate can increase, which has a technical problem in that the transfer yield decreases.

In the related technology, a self-assembly transfer process using dielectrophoresis (DEP) is attempted, but there is a problem that the self-assembly rate is low due to the non-uniformity of the DEP force.

On the other hand, in the self-assembly method, since the red light-emitting element, the green light-emitting element, and the blue light-emitting element are individually injected, assembled, and recovered, there is a problem that the process time is very long. In addition, when a light-emitting element that was not recovered in the previous process is assembled with another light-emitting element, a light-emitting element that emits light of a different color in a specific color area is assembled, so that there was a problem that color mixing occurred and it was difficult to implement full color.

On the other hand, since the red light-emitting element, the green light-emitting element, and the blue light-emitting element must be disposed in the pixel of the display substrate, it is difficult to reduce the size of the pixels, making it difficult to implement ultra-high resolution.

### [Disclosure]

### [Technical Problem]

An object of the embodiment is to solve the foregoing and other problems.

Another object of the embodiment is to provide a light-emitting element package and a display device capable of improving the assembly speed.

In addition, another object of the embodiment is to provide a light-emitting element package and a display device capable of preventing color mixing defects.

In addition, another object of the embodiment is to provide a light-emitting element package and a display device capable of implementing ultra-high resolution.

The technical problems of the embodiments are not limited to those described in this item and include those that may be understood through the description of the invention.

### [Technical Solution]

In order to achieve the above or other objects, according to one aspect of the embodiment, a semiconductor light-emitting element package, comprising: a common connection electrode having a first region and a second region; a first semiconductor light-emitting element on the first region of the common connection electrode; a pair of first assembling wirings on the second region of the common connection electrode; and a second semiconductor light-emitting element on the pair of first assembling wirings.

The semiconductor light-emitting element package may comprise a third semiconductor light-emitting element on the pair of first assembling wirings.

The common connection electrode may have a third region, and the second region may be positioned between the first region and the third region. In this instance, the semiconductor light-emitting element package may comprise a fourth semiconductor light-emitting element on the third region of the common connection electrode; and a fifth semiconductor light-emitting element and a sixth semiconductor light-emitting element on the pair of first assembling wirings.

The first semiconductor light-emitting element and the fourth semiconductor light-emitting element may be red semiconductor light-emitting elements, the second semiconductor light-emitting element and the fifth semiconductor light-emitting element may be green semiconductor light-emitting elements, and the third semiconductor light-emitting element and the sixth semiconductor light-emitting element may be blue semiconductor light-emitting elements.

The first semiconductor light-emitting element, the second semiconductor light-emitting element, and the third semiconductor light-emitting element may constitute a first pixel, and the fourth semiconductor light-emitting element, the fifth semiconductor light-emitting element, and the sixth semiconductor light-emitting element may constitute a second pixel.

The first semiconductor light-emitting element, the second semiconductor light-emitting element, and the third semiconductor light-emitting element may constitute a pixel, and the fourth semiconductor light-emitting element, the fifth semiconductor light-emitting element, and the sixth semiconductor light-emitting element may constitute a dummy pixel.

The second semiconductor light-emitting element, the third semiconductor light-emitting element, the fifth semiconductor light-emitting element, and the sixth semiconductor light-emitting element may be disposed between the first semiconductor light-emitting element and the fourth semiconductor light-emitting element.

The third semiconductor light-emitting element and the sixth semiconductor light-emitting element may be disposed between the second semiconductor light-emitting element and the fifth semiconductor light-emitting element.

The common connection electrode may be connected to a lower side of each of the first semiconductor light-emitting element and the fourth semiconductor light-emitting element, and may be connected to a lower side of each of the second semiconductor light-emitting element, the third semiconductor light-emitting element, the fifth semiconductor light-emitting element, and the sixth semiconductor light-emitting element between the pair of first assembling wirings.

The common connection electrode may be connected to a lower side of each of the pair of first assembling wirings.

The semiconductor light-emitting element package may comprise a first common pad on one side of the first semiconductor light-emitting element; and a second common pad on one side of the fourth semiconductor light-emitting element.

The first common pad may be connected to a first assembling wiring of the pair of first assembling wirings, and the second common pad may be connected to a second assembling wiring of the pair of first assembling wirings.

The first common pad and the second common pad may be positioned diagonally.

The first semiconductor light-emitting element and the fourth semiconductor light-emitting element may comprise a GaAs-based semiconductor material, and the second semiconductor light-emitting element, the third semiconductor light-emitting element, the fifth semiconductor light-emitting element, and the sixth semiconductor light-emitting element may each comprise a GaN-based semiconductor material.

Each of the second semiconductor light-emitting element, the third semiconductor light-emitting element, the fifth semiconductor light-emitting element, and the sixth semiconductor light-emitting element may comprise a magnetic layer.

The common connection electrode may comprise a reflective layer.

The common connection electrode may have a third region, and the first region may be positioned between the second region and the third region. **In** this instance, the semiconductor light-emitting element package may comprise a pair of second assembling wirings on the third region of the common connection electrode; and a third semiconductor light-emitting element on the pair of second assembling wirings.

At least one of the common connection electrode, the pair of first assembling wirings, or the pair of second assembling wirings may comprise a magnetic layer.

According to another aspect of the embodiment, a display device, comprising: a panel substrate comprising a plurality of pixels; a pair of first assembling wirings corresponding to each of the plurality of pixels; a partition wall comprising an assembly hole on the pair of first assembling wirings; and a semiconductor light-emitting element package in the assembly hole, wherein the semiconductor light-emitting element package comprises: a common connection electrode having a first region and a second region; a first semiconductor light-emitting element on the first region of the common connection electrode; a pair of second assembly wirings on the second region of the common connection electrode; and a second semiconductor light-emitting element and a third semiconductor light-emitting element on the pair of second assembly wirings.

### [Advantageous Effects]

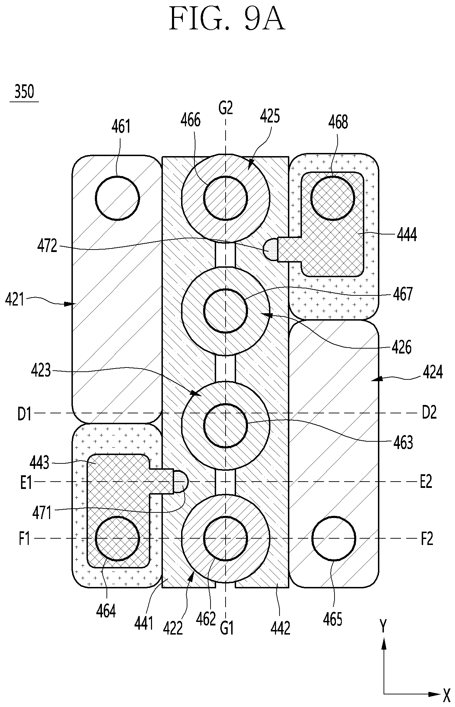

As illustrated in FIG. 9A, a semiconductor light-emitting device package 350 comprising a plurality of semiconductor light-emitting devices 421 to 426 capable of displaying an image may be assembled on a display substrate 310 using a self-assembly method, so that assembly defects caused by individually assembling the semiconductor light-emitting devices can be prevented and the assembly speed can be dramatically improved.

In addition, by assembling the semiconductor light-emitting element package 350 comprising a plurality of semiconductor light-emitting elements 421 to 426, the process speed can be dramatically improved compared to when the semiconductor light-emitting elements are individually assembled.

Meanwhile, when semiconductor light-emitting elements are assembled individually, a color mixing defect occurs because the semiconductor light-emitting elements are assembled in different assembly holes. However, as in the embodiment, since a semiconductor light-emitting element package 350 comprising a plurality of semiconductor light-emitting elements 421, 422, and 423 is assembled, the color mixing defect can be prevented.

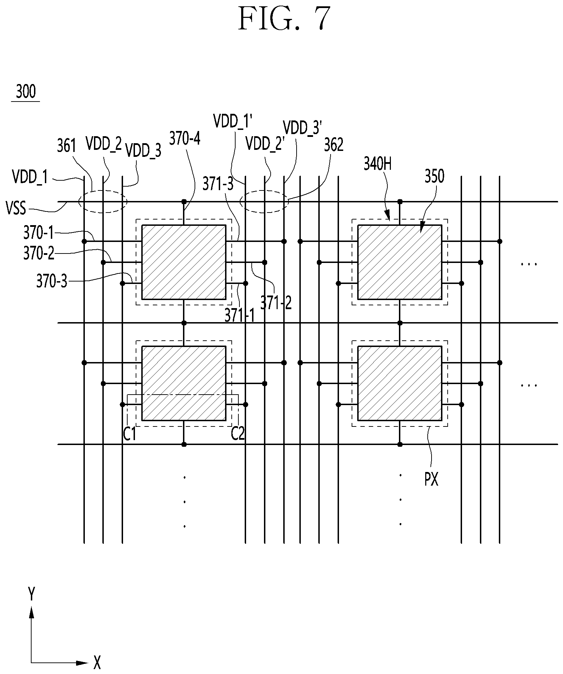

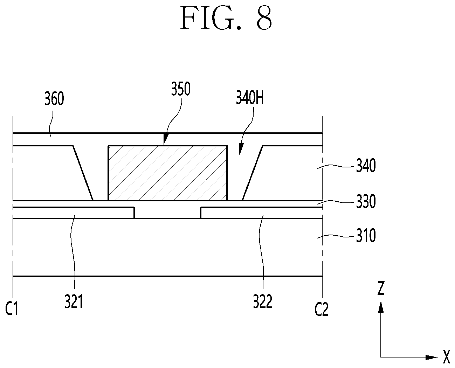

When semiconductor light-emitting elements are assembled individually, assembly holes for assembling these semiconductor light-emitting elements are provided on the display substrate. In this instance, a minimum distance between the assembly holes is required, making it difficult to implement high resolution. However, as in the embodiment, a semiconductor light-emitting element package 350 comprising a plurality of semiconductor light-emitting elements 421 to 426 is manufactured using a semiconductor process, thereby reducing the distance between the semiconductor light-emitting elements 421 to 426. By manufacturing a display device (300 of FIGS. 7 and 8) based on the semiconductor light-emitting element package 350 in which the distance between the semiconductor light-emitting elements 421 to 426 is reduced in this way, an ultra-high resolution can be implemented.

Meanwhile, since a magnetic layer is included in each of the plurality of semiconductor light-emitting elements 421 to 426 and/or a pair of assembling wirings within the semiconductor light-emitting element package 350, the semiconductor light-emitting element package 350 may be moved more easily by the magnet during self-assembly, so that the mobility of the semiconductor light-emitting element package 350 may be increased, thereby improving the assembly speed. In addition, since the semiconductor light-emitting element package 350 comprising a plurality of semiconductor light-emitting elements 421 to 426 is larger, the semiconductor light-emitting element package 350 is more strongly affected by the DEP force formed on the display substrate 310, so that the semiconductor light-emitting element package 350 can be assembled into the assembly hole 340H more quickly and stably, thereby improving the assembly speed and preventing assembly defects.

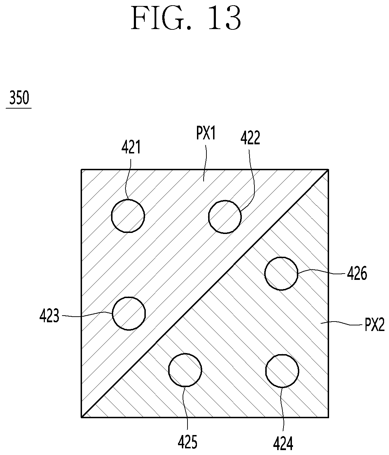

Meanwhile, the semiconductor light-emitting element package 350 of the embodiment may comprise a plurality of semiconductor light-emitting elements 421 to 426 to form two pixels PX1 and PX2, as illustrated in FIG. 13, so that the resolution can be further improved.

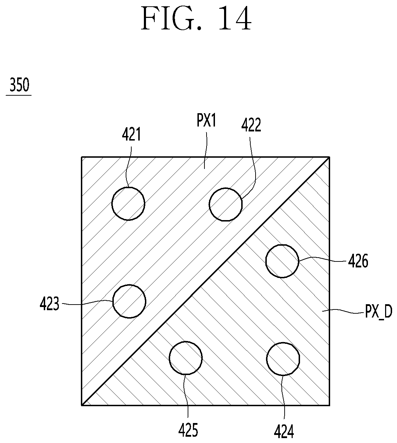

In addition, the semiconductor light-emitting element package 350 of the embodiment may comprise a plurality of semiconductor light-emitting elements 421 to 426 to configure one pixel PX and a dummy pixel PX_D, as illustrated in FIG. 14, so that even if the semiconductor light-emitting elements 421 to 423 in the pixel PX fail, they may be replaced with the semiconductor light-emitting elements 424 to 426 in the dummy pixel PX_D, thereby significantly improving the yield.

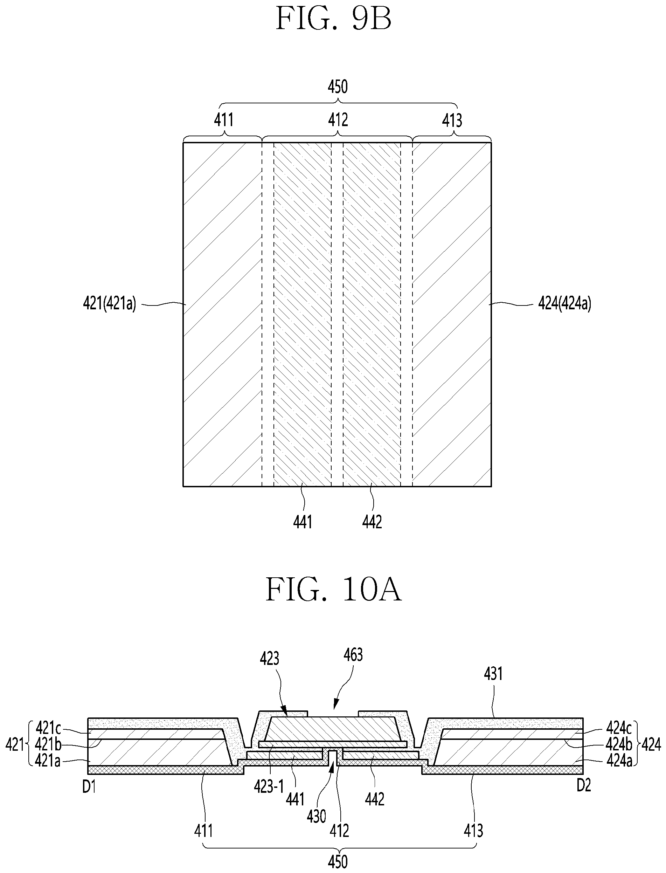

Meanwhile, the common connection electrode 450 may comprise a reflective layer. The reflective layer of the common connection electrode 450 may reflect light that has traveled downward from the first semiconductor light-emitting element 421 or the fourth semiconductor light-emitting element 424 upward, as illustrated in FIGS. 10A to 10D. The reflective layer of the common connection electrode 450 may reflect the light that has traveled downward through the recess 430 between a pair of assembling wirings 441 and 442 of the second and third semiconductor light-emitting elements 422 and 423 or the fifth and sixth semiconductor light-emitting elements 425 and 426 upward. Therefore, the luminance can be improved by increasing the light efficiency or light output toward the front by the reflection layer of the common connection electrode 450.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates a living room of a house in which a display device according to an embodiment is arranged.
FIG. 2 is a block diagram schematically showing a display device according to an embodiment.
FIG. 3 is a circuit diagram showing an example of a pixel of FIG. 2.
FIG. 4 is an enlarged view of the first panel area of the display device of FIG. 1.
FIG. 5 is an enlarged view of the A2 area of FIG. 4.
FIG. 6 is a diagram illustrating an example of assembling a light-emitting element according to an embodiment on a substrate by a self-assembly method.
FIG. 7 is a diagram illustrating a display device according to an embodiment.
FIG. 8 is a cross-sectional view schematically illustrating a display device according to an embodiment.
FIG. 9A is a plan view illustrating a semiconductor light-emitting element package according to the first embodiment.
FIG. 9B is a bottom view illustrating a semiconductor light-emitting element package according to the first embodiment.
FIG. 10A is a cross-sectional view cut along the line D1-D2 of the semiconductor light-emitting element package according to the first embodiment of FIG. 9A.
FIG. 10B is a cross-sectional view taken along line E1-E2 in the semiconductor light-emitting element package according to the first embodiment of FIG. 9A.
FIG. 10C is a cross-sectional view taken along line F1-F2 in the semiconductor light-emitting element package according to the first embodiment of FIG. 9A.
FIG. 10D is a cross-sectional view taken along line G1-G2 in the semiconductor light-emitting element package according to the first embodiment of FIG. 9A.
FIG. 11A is a cross-sectional view illustrating a second semiconductor light-emitting element.
FIG. 11B is a cross-sectional view illustrating a third semiconductor light-emitting element.
FIG. 12 illustrates a plurality of semiconductor light-emitting element packages manufactured on a wafer.
FIG. 13 illustrates two pixels formed by the first to sixth semiconductor light-emitting elements.
FIG. 14 illustrates one pixel formed by the first to sixth semiconductor light-emitting elements and one dummy pixel.
Figures 15 to 28 illustrate a manufacturing process of a semiconductor light-emitting element package according to the first embodiment.
Figure 29 is a plan view illustrating a plurality of semiconductor light-emitting element packages according to the second embodiment manufactured on a wafer.

The sizes, shapes, dimensions, etc. of elements shown in the drawings may differ from actual ones. In addition, even if the same elements are shown in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile phone, a smart phone, a head-up display (HUD) for an automobile, a backlight unit for a laptop computer, a display for VR or AR, etc. However, the configuration according to the embodiment described in this specification may be applied to a device capable of displaying, even if it is a new product type developed in the future.

A light-emitting element and a display device including the same according to an embodiment will be described.

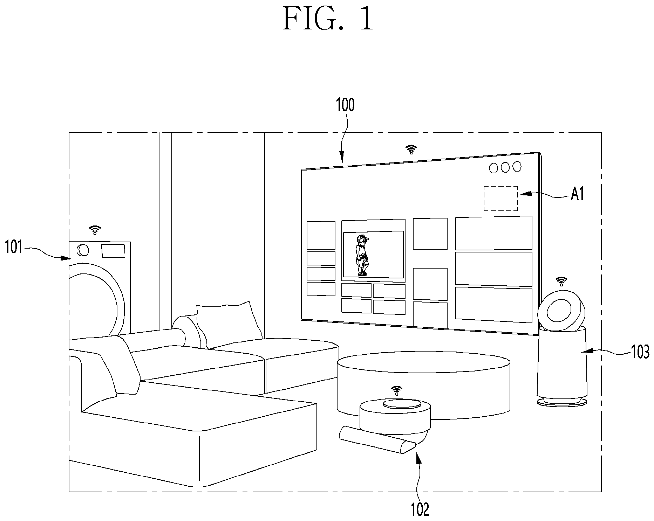

FIG. 1 illustrates a living room of a house in which a display device according to an embodiment is arranged.

Referring to FIG. 1, the display device 100 according to the embodiment may display the status of various electronic products such as a washing machine 101, a robot vacuum cleaner 102, and an air purifier 103, etc. and may communicate with each electronic product based on IoT and control each electronic product based on the user's setting data.

The display device 100 according to the embodiment may comprise a flexible display manufactured on a thin and flexible substrate. The flexible display may be bent or rolled like paper while maintaining the characteristics of an existing flat display.

In the flexible display, visual information may be implemented by independently controlling the light emission of unit pixels disposed in a matrix form. A unit pixel means a minimum unit for implementing one color. The unit pixel of the flexible display may be implemented by a light-emitting element. In the embodiment, the light-emitting element may be a Micro-LED or a Nano-LED, but is not limited thereto.

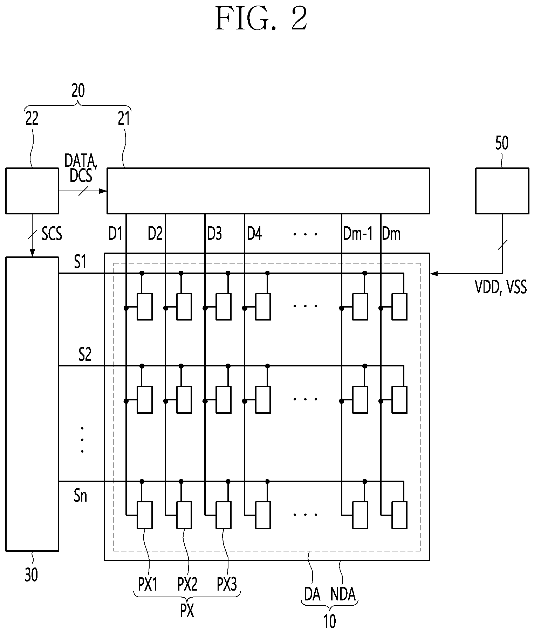

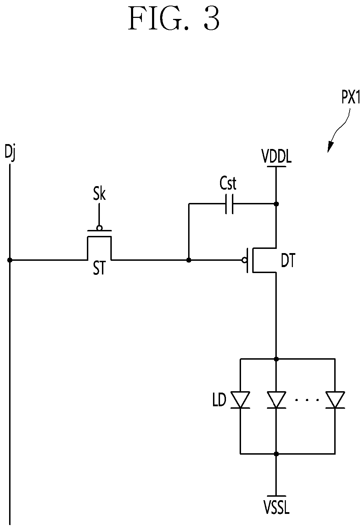

FIG. 2 is a block diagram schematically showing a display device according to an embodiment, and FIG. 3 is a circuit diagram showing an example of a pixel of FIG. 2.

Referring to FIG. 2 and FIG. 3, the display device according to the embodiment may comprise a display panel 10, a driving circuit 20, a scan driver 30, and a power supply circuit 50.

The display device 100 of the embodiment may drive a light-emitting element in an active matrix (AM) method or a passive matrix (PM) method.

The driving circuit 20 may comprise a data driver 21 and a timing controller 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel 10 may be divided into a display area DA and a non-display area NDA disposed around the display area DA. The display area DA is an area where pixels PX are formed to display an image. The display panel 10 may comprise data lines (D1 to Dm, m is an integer greater than or equal to 2), scan lines (S1 to Sn, n is an integer greater than or equal to 2) crossing the data lines D1 to Dm, a high-potential voltage line VDDL to which a high-potential voltage is supplied, a low-potential voltage line VSSL to which a low-potential voltage is supplied, and pixels PX connected to the data lines D1 to Dm and the scan lines S1 to Sn.

Each of the pixels PXs may comprise a first sub-pixel PX1, a second sub-pixel PX2, and a third sub-pixel PX3. The first sub-pixel PX1 may emit a first color light of a first dominant wavelength, the second sub-pixel PX2 may emit a second color light of a second dominant wavelength, and the third sub-pixel PX3 may emit a third color light of a third dominant wavelength. The first color light may be red light, the second color light may be green light, and the third color light may be blue light, but is not limited thereto. In addition, although FIG. 2 exemplifies that each of the pixels PXs comprises three sub-pixels, it is not limited thereto. That is, each of the pixels PXs may comprise four or more sub-pixels.

Each of the first sub-pixel PX1, the second sub-pixel PX2, and the third sub-pixel PX3 may be connected to at least one of the data lines D1 to Dm, at least one of the scan lines S1 to Sn, and a high-potential voltage line VDDL. The first sub-pixel PX1 may comprise light-emitting elements LD, a plurality of transistors for supplying current to the light-emitting elements LD, and at least one capacitor Cst, as shown in FIG. 3.

Although not shown in the drawing, each of the first sub-pixel PX1, the second sub-pixel PX2, and the third sub-pixel PX3 may comprise only one light-emitting element LD and at least one capacitor Cst.

Each of the light-emitting elements LD may be a semiconductor light-emitting diode comprising a first electrode, a plurality of conductivity type semiconductor layers, and a second electrode. Here, the first electrode may be an anode electrode, and the second electrode may be a cathode electrode, but is not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting element LD, and a scan transistor ST for supplying a data voltage to a gate electrode of the driving transistor DT, as shown in FIG. 3. The driving transistor DT may comprise a gate electrode connected to a source electrode of the scan transistor ST, a source electrode connected to a high-potential voltage line VDDL to which a high-potential voltage is applied, and a drain electrode connected to the first electrodes of the light-emitting element LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst is formed between the gate electrode and the source electrode of the driving transistor DT. The storage capacitor Cst charges the difference between the gate voltage and the source voltage of the driving transistor DT.

The driving transistor DT and the scan transistor ST may be formed as thin film transistors. In addition, in FIG. 3, the driving transistor DT and the scan transistor ST are described mainly as being formed as a P-type metal oxide semiconductor field effect transistor (MOSFET), but the present invention is not limited thereto. The driving transistor DT and the scan transistor ST may be formed as N-type MOSFETs. In this instance, the positions of the source electrode and the drain electrode of each of the driving transistor DT and the scan transistor ST may be changed.

In addition, in FIG. 3, it is exemplified that each of the first sub-pixel PX1, the second sub-pixel PX2, and the third sub-pixel PX3 comprises 2T1C (2 Transistor - 1 capacitor) having one driving transistor DT, one scan transistor ST, and one capacitor Cst, but the present invention is not limited thereto. Each of the first sub-pixel PX1, the second sub-pixel PX2, and the third sub-pixel PX3 may comprise a plurality of scan transistors STs and a plurality of capacitors Csts.

Since the second sub-pixel PX2 and the third sub-pixel PX3 may be expressed by substantially the same circuit diagram as the first sub-pixel PX1, a detailed description thereof will be omitted.

The driving circuit 20 outputs signals and voltages for driving the display panel 10. To this end, the driving circuit 20 may comprise a data driver 21 and a timing controller 22.

The timing controller 22 receives digital video data DATA and timing signals from a host system. The timing signals may comprise a vertical synchronization signal, a horizontal synchronization signal, a data enable signal, and a dot clock. The host system may be an application processor of a smartphone or tablet PC, a monitor, a system on chip of a TV, etc.

The timing controller 22 generates control signals for controlling the operation timing of the data driver 21 and the scan driver 30. The control signals may comprise a source control signal DCS for controlling the operation timing of the data driver 21 and a scan control signal SCS for controlling the operation timing of the scan driver 30.

The scan driver 30 receives a scan control signal SCS from the timing controller 22. The scan driver 30 generates scan signals according to the scan control signal SCS and supplies them to the scan lines S1 to Sn of the display panel 10. The scan driver 30 may be formed in a non-display area NDA of the display panel 10 and comprise a plurality of transistors. Alternatively, the scan driver 30 may be formed as an integrated circuit, in which case it may be mounted on a gate flexible film attached to the other side of the display panel 10.

The data driver 21 receives digital video data DATA and a source control signal DCS from the timing controller 22. The data driver 21 converts the digital video data DATA into analog data voltages according to the source control signal DCS and supplies them to the data lines D1 to Dm of the display panel 10.

The power supply circuit 50 may generate voltages necessary for driving the display panel 10 from a main power applied from a system board and supply them to the display panel 10. For example, the power supply circuit 50 may generate a high-potential voltage VDD and a low-potential voltage VSS for driving the light-emitting elements LD of the display panel 10 from the main power supply and supply them to the high-potential voltage line VDDL and the low-potential voltage line VSSL of the display panel 10. In addition, the power supply circuit 50 may generate and supply driving voltages for driving the driving circuit 20 and the scan driver 30 from the main power supply.

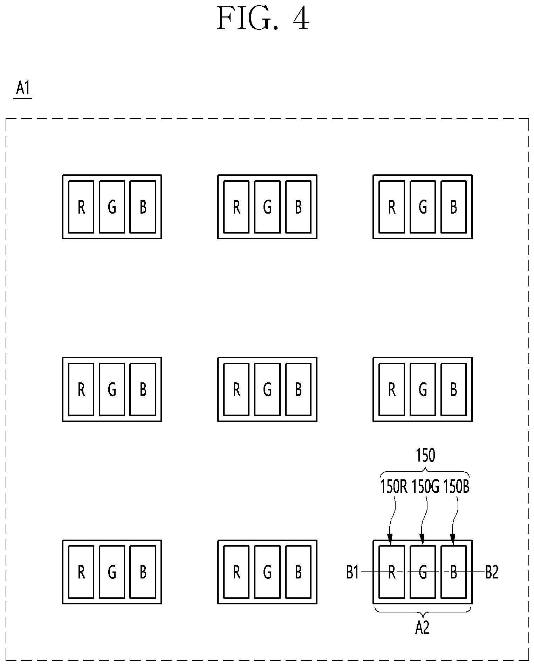

FIG. 4 is an enlarged view of the first panel area in the display device of FIG. 3.

Referring to FIG. 4, the display device 100 of the embodiment may be manufactured by mechanically and electrically connecting a plurality of panel areas such as the first panel area A1 by tiling.

Alternatively, the plurality of panel areas may be configured as a single display panel formed integrally.

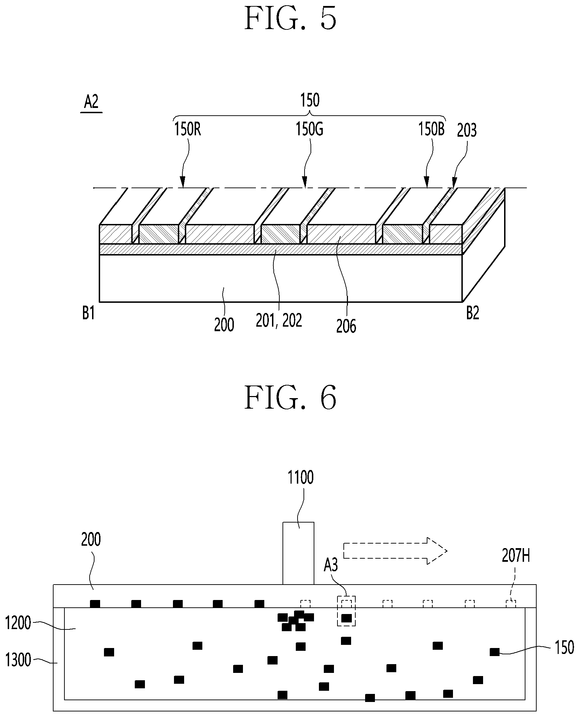

FIG. 5 is an enlarged view of the A2 area of FIG. 4.

Referring to FIG. 5, the display device 100 of the embodiment may comprise a substrate 200, assembling wiring 201 and 202, an insulating layer 206, and a plurality of semiconductor light-emitting elements 150. More components may be included than these.

The assembling wiring may comprise a first assembling wiring 201 and a second assembling wiring 202 that are spaced apart from each other. The first assembling wiring 201 and the second assembling wiring 202 may be provided to generate a dielectrophoretic force (DEP force) to assemble the semiconductor light-emitting element 150. For example, the semiconductor light-emitting element 150 may be one of a lateral-type semiconductor light-emitting element, a flip-chip type semiconductor light-emitting element, and a vertical-type semiconductor light-emitting element.

The semiconductor light-emitting element 150 may comprise, but is not limited to, a red semiconductor light-emitting element 150R, a green semiconductor light-emitting element 150G, and a blue semiconductor light-emitting element 150B to form a unit pixel (sub-pixel), and may also comprise a red phosphor and a green phosphor to implement red and green, respectively.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 may function as a support substrate in the display panel, and may also function as an assembly substrate when self-assembling the light-emitting element.

The substrate 200 may be a backplane equipped with circuits, such as transistors ST and DT, capacitors Cst, and signal wiring, within the sub-pixels PX1, PX2, and PX3 illustrated in FIGS. 2 and 3, but is not limited thereto.

The insulating layer 206 may comprise an organic material having insulation and flexibility, such as polyimide, PAC, PEN, PET, polymer, or an inorganic material, such as silicon oxide (SiO2) or silicon nitride series (SiNx), and may be formed integrally with the substrate 200 to form a single substrate.

The insulating layer 206 may be a conductive adhesive layer having adhesiveness and conductivity, and the conductive adhesive layer may have flexibility to enable a flexible function of the display device. For example, the insulating layer 206 may be an anisotropic conductive film (ACF) or a conductive adhesive layer such as an anisotropic conductive medium, a solution containing conductive particles, etc. The conductive adhesive layer may be a layer that is electrically conductive in a direction perpendicular to the thickness, or electrically insulating in a direction horizontal to the thickness.

The insulating layer 206 may comprise an assembly hole 203 for inserting the semiconductor light-emitting element 150. Accordingly, during self-assembly, the semiconductor light-emitting element 150 may be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may be different depending on the shape of the semiconductor light-emitting element 150. For example, the red semiconductor light-emitting element, the green semiconductor light-emitting element, and the blue semiconductor light-emitting element each has a different shape, and may have an assembly hole 203 having a shape corresponding to each of the shapes of these semiconductor light-emitting elements. For example, the assembly hole 203 may comprise a first assembly hole for assembling the red semiconductor light-emitting element, a second assembly hole for assembling the green semiconductor light-emitting element, and a third assembly hole for assembling the blue semiconductor light-emitting element. For example, the red semiconductor light-emitting element may have a circular shape, the green semiconductor light-emitting element may have a first oval shape having a first minor axis and a second major axis, and the blue semiconductor light-emitting element may have a second oval shape having a second minor axis and a second major axis, but are not limited thereto. The second major axis of the oval shape of the blue semiconductor light-emitting element may be greater than the first major axis of the oval shape of the green semiconductor light-emitting element, and the second minor axis of the oval shape of the blue semiconductor light-emitting element may be smaller than the first minor axis of the oval shape of the green semiconductor light-emitting element.

Meanwhile, the method of mounting the semiconductor light-emitting element 150 on the substrate 200 may comprise, for example, a self-assembly method (FIG. 6) and a transfer method.

FIG. 6 is a drawing illustrating an example in which a light-emitting element according to an embodiment is assembled on a substrate by a self-assembly method.

Based on FIG. 6, an example in which a semiconductor light-emitting element according to an embodiment is assembled on a display panel by a self-assembly method using an electromagnetic field will be described.

The assembling substrate 200 described below may also function as a display substrate 200a in a display device after assembling the light-emitting element, but the embodiment is not limited thereto.

Referring to FIG. 6, the semiconductor light-emitting element 150 may be put into a chamber 1300 filled with a fluid 1200, and the semiconductor light-emitting element 150 may be moved to the assembling substrate 200 by a magnetic field generated from the assembly device 1100. At this time, the light-emitting element 150 adjacent to the assembly hole 207H of the assembling substrate 200 may be assembled into the assembly hole 207H by the DEP force caused by the electric field of the assembling wirings. The fluid 1200 may be water such as ultrapure water, but is not limited thereto. The chamber may be called a tank, a container, a vessel, etc.

After the semiconductor light-emitting element 150 is put into the chamber 1300, the assembling substrate 200 may be disposed on the chamber 1300. According to an embodiment, the assembly substrate 200 may be put into the chamber 1300.

The semiconductor light-emitting element 150 may be a lateral-type semiconductor light-emitting element, a vertical-type semiconductor light-emitting element, or a flip-chip type semiconductor light-emitting element.

The semiconductor light-emitting element 150 may comprise a magnetic layer (not illustrated) having a magnetic substance. The magnetic layer may comprise a metal having magnetism, such as nickel (Ni). Since the semiconductor light-emitting element 150 put into the fluid comprises the magnetic layer, it may move to the assembly substrate 200 by a magnetic field generated from the assembly device 1100. The magnetic layer may be disposed on the upper side, the lower side or both sides of the light-emitting element.

The semiconductor light-emitting element 150 may comprise a passivation layer 156 surrounding the upper surface and the side surface thereof. The passivation layer 156 may be formed by using an inorganic insulator such as silica or alumina through PECVD, LPCVD, sputtering deposition, etc. In addition, the passivation layer 156 may be formed by using a method of spin coating an organic material such as a photoresist or a polymer material.

The semiconductor light-emitting element 150 may comprise a first conductivity type semiconductor layer, a second conductivity type semiconductor layer, and an active layer disposed therebetween. The first conductivity type semiconductor layer may be an n-type semiconductor layer, and the second conductivity type semiconductor layer may be a p-type semiconductor layer, but is not limited thereto. The first conductivity type semiconductor layer, the second conductivity type semiconductor layer, and the active layer disposed therebetween may constitute a light-emitting portion. The light-emitting portion may be referred to as a light-emitting layer, a light-emitting region, etc.

The first electrode (layer) may be disposed under the first conductivity type semiconductor layer, and the second electrode (layer) may be disposed on the second conductivity type semiconductor layer. To this end, a part of the first conductivity type semiconductor layer or the second conductivity type semiconductor layer may be exposed to the outside. Accordingly, after the semiconductor light-emitting element 150 is assembled on the assembly substrate 200, a part of the passivation layer may be etched in the manufacturing process of the display device.

The first electrode may comprise at least one or more layer. For example, the first electrode may comprise an ohmic layer, a reflective layer, a magnetic layer, a conductive layer, an anti-oxidation layer, an adhesive layer, etc. The ohmic layer may comprise Au, AuBe, etc. The reflective layer may comprise Al, Ag, etc. The magnetic layer may comprise Ni, Co, etc. The conductive layer may comprise Cu, etc. The anti-oxidation layer may comprise Mo, etc. The adhesive layer may comprise Cr, Ti, etc.

The second electrode may comprise a transparent conductive layer. For example, the second electrode may comprise ITO, IZO, etc.

The assembling substrate 200 may comprise a first assembling wiring 201 and a second assembling wiring 202 corresponding to each of the semiconductor light-emitting elements 150 to be assembled. Each of the first assembling wiring 201 and the second assembling wiring 202 may be formed by laminating a single metal or a metal alloy, a metal oxide, etc. in multiple layers. For example, each of the first assembling wiring 201 and the second assembling wiring 202 may be formed by comprising at least one of Cu, Ag, Ni, Cr, Ti, Al, Rh, Pd, Ir, Ru, Mg, Zn, Pt, Au, and Hf, but is not limited thereto.

The first assembling wiring 201 and the second assembling wiring 202 may form an electric field when an AC voltage is applied, and the semiconductor light-emitting element 150 inserted into the assembly hole 207H may be fixed by the DEP force caused by the electric field. The gap between the first assembling wiring 201 and the second assembling wiring 202 may be smaller than the width of the semiconductor light-emitting element 150 and the width of the assembly hole 207H, and the assembly position of the semiconductor light-emitting element 150 may be more precisely fixed using an electric field.

An insulating layer 215 may be formed on the first assembling wiring 201 and the second assembling wiring 202 to protect the first assembling wiring 201 and the second assembling wiring 202 from the fluid 1200 and prevent leakage of current flowing through the first assembling wiring 201 and the second assembling wiring 202. For example, the insulating layer 215 may be formed of an inorganic insulator such as silica or alumina, or an organic insulator in a single layer or multiple layers. The insulating layer 215 may have a minimum thickness for preventing damage to the first assembling wiring 201 and the second assembling wiring 202 during assembly of the semiconductor light-emitting element 150, and may have a maximum thickness for stably assembling the semiconductor light-emitting element 150.

A partition wall 207 may be formed on the upper portion of the insulating layer 215. Some regions of the partition wall 207 may be positioned on the upper portion of the first assembling wiring 201 and the second assembling wiring 202, and the remaining regions may be positioned on the upper portion of the assembling substrate 200.

Meanwhile, when manufacturing the assembling substrate 200, a part of the partition walls formed on the upper portion of the insulating layer 215 may be removed, thereby forming an assembly hole 207H in which each of the semiconductor light-emitting elements 150 is coupled and assembled to the assembling substrate 200.

An assembly hole 207H may be formed in the assembling substrate 200, into which semiconductor light-emitting elements 150 are combined, and a surface on which the assembly hole 207H is formed may be in contact with a fluid 1200. The assembly hole 207H may guide an accurate assembly position of the semiconductor light-emitting element 150.

Meanwhile, the assembly hole 207H may have a shape and size corresponding to the shape of the semiconductor light-emitting element 150 to be assembled at a corresponding position. Accordingly, the assembly of another semiconductor light-emitting device in the assembly hall 207H or the assembly of multiple semiconductor light-emitting devices in the assembly hall 207H can be prevented.

Referring again to FIG. 6, after the assembling substrate 200 is disposed in the chamber, an assembly device 1100 that applies a magnetic field may move along the assembling substrate 200. The assembly device 1100 may be a permanent magnet or an electromagnet.

The assembly device 1100 may move in contact with the assembly substrate 200 to maximize the area affected by the magnetic field within the fluid 1200. Depending on the embodiment, the assembly device 1100 may comprise a plurality of magnetic substances or may comprise magnetic substances of a size corresponding to the assembly substrate 200. In this instance, the movement distance of the assembly device 1100 may be limited within a predetermined range.

The semiconductor light-emitting element 150 within the chamber 1300 may move toward the assembly device 1100 and the assembly substrate 200 by the magnetic field generated by the assembly device 1100.

The semiconductor light-emitting element 150 may enter the assembly hole 207H and be fixed by the DEP force formed by the electric field between the assembling wirings 201 and 202 while moving toward the assembly device 1100.

Specifically, the first and second assembling wirings 201 and 202 may form an electric field by an AC power source, and a DEP force may be formed between the assembling wirings 201 and 202 by this electric field. The semiconductor light-emitting element 150 may be fixed to the assembly hole 207H on the assembling substrate 200 by this DEP force.

At this time, a predetermined solder layer (not illustrated) may be formed between the light-emitting element 150 assembled on the assembly hole 207H of the assembling substrate 200 and the assembling wirings 201 and 202, thereby improving the bonding strength of the light-emitting element 150.

In addition, a molding layer (not illustrated) may be formed in the assembly hole 207H of the assembling substrate 200 after assembly. The molding layer may be a transparent resin or a resin containing a reflective material or a scattering material.

Since the time required for each semiconductor light-emitting element to be assembled on the substrate may be drastically shortened by the self-assembly method using the electromagnetic field described above, a large-area, high-pixel display can be implemented more quickly and economically.

Hereinafter, various embodiments for solving the above-described problem will be described with reference to FIGS. 7 to 29. The description omitted below may be easily understood from the description described above with respect to FIGS. 1 to 6 and the corresponding drawings.

FIG. 7 is a drawing illustrating a display device according to an embodiment. FIG. 8 is a cross-sectional view schematically illustrating a display device according to an embodiment.

Referring to FIGS. 7 and 8, a display device 300 according to an embodiment may comprise a display substrate 310, a plurality of semiconductor light-emitting element packages 350, and a first signal line group 361.

The display substrate 310 may serve as a supporting member supporting various components of the display device 300.

A plurality of assembly holes 340H may be provided on the display substrate 310. For example, a partition wall 340 may be disposed on the display substrate 310, and a plurality of assembly holes 340H may be formed in the partition wall 340.

A plurality of pixels PX may be defined on the display substrate 310. For example, at least one assembly hole 340H may be provided in one pixel PX. A semiconductor light-emitting element package 350 may be disposed in the assembly hole 340H of the partition wall 340. Accordingly, at least one semiconductor light-emitting element package 350 may be provided in one pixel PX.

The semiconductor light-emitting element package 350 of the first embodiment may be assembled in the assembly hole 340H using a self-assembly method. The self-assembly method has been described in detail above with reference to FIG. 6, so a detailed description thereof will be omitted.

In the first embodiment, a plurality of semiconductor light-emitting element packages 350 may be assembled into a plurality of assembly holes 340H using a self-assembly method. To this end, a first assembling wiring 321 and a second assembling wiring 322 may be disposed in the assembly hole 340H of the display substrate 310, and an insulating layer (330, hereinafter referred to as a first insulating layer) may be disposed on the first assembling wiring 321 and the second assembling wiring 322 to insulate the first assembling wiring 321 and the second assembling wiring 322. In this instance, a bottom portion of the assembly hole 340H may be a part of an upper surface of the first insulating layer 330. That is, a part of the upper surface of the first insulating layer 330 may be exposed by the assembly hole 340H.

For example, a shape of the assembly hole 340H may correspond to a shape of the semiconductor light-emitting element package 350. In the first embodiment, since the semiconductor light-emitting element package 350 has a square shape when viewed from above, the assembly hole 340H may also have a square shape. For example, a size of the assembly hole 340H may be greater than a size of the semiconductor light-emitting element package 350. That is, when the semiconductor light-emitting element package 350 is inserted into the assembly hole 340H, an outer side surface of the semiconductor light-emitting element package 350 may be spaced apart from an inner side surface of the assembly hole 340H.

According to the first embodiment, since the semiconductor light-emitting element package 350 and the assembly hole 340H have a square shape, when the semiconductor light-emitting element package 350 is assembled into the assembly hole 340H, the semiconductor light-emitting element package 350 may maintain the current assembled state without being rotated due to the square shape of the assembly hole 340H, thereby enhancing the fixing force of the semiconductor light-emitting element package 350.

After the semiconductor light-emitting element package 350 is assembled into the assembly hole 340H, an insulating layer (360, hereinafter referred to as a second insulating layer) may be formed on the semiconductor light-emitting element package 350 and the partition wall 340. Although not illustrated, a black matrix may be disposed between the pixels PX to distinguish between the pixels PX. The black matrix may be disposed on the partition wall 340 excluding the assembly hole 340H between the partition wall 340 and the second insulating layer 360, but is not limited thereto.

Meanwhile, the semiconductor light-emitting element package 350 may generate a plurality of different color lights. A color image may be displayed by the plurality of color lights. The plurality of semiconductor light-emitting element packages 350 may be disposed in a plurality of pixels PX, respectively.

The semiconductor light-emitting element package 350 of the first embodiment may comprise a first semiconductor light-emitting element 421, a second semiconductor light-emitting element 422, and a third semiconductor light-emitting element 423, as illustrated in FIGS. 9A and 9B. The first semiconductor light-emitting element 421, the second semiconductor light-emitting element 422, and the third semiconductor light-emitting element 423 may emit different color lights to display an image. For example, the first semiconductor light-emitting element 421 may be a red semiconductor light-emitting element, the second semiconductor light-emitting element 422 may be a green semiconductor light-emitting element, and the third semiconductor light-emitting element 423 may be a blue semiconductor light-emitting element, but are not limited thereto.

Meanwhile, the first signal line group 361 may be disposed on one side of each of the plurality of assembly holes 340H and may comprise a plurality of signal lines VDD_1, VDD_2, VDD_3, and VSS. Although not illustrated, a driving transistor (DT of FIG. 3) may be connected between each of the plurality of signal lines VDD_1, VDD_2, VDD_3, and VSS and the pixel PX.

The plurality of signal lines VDD_1, VDD_2, VDD_3, and VSS may be connected to each of the plurality of pixels PX. Each of the plurality of pixels PX may comprise at least one semiconductor light-emitting element package 350. In this instance, the plurality of signal lines VDD_1, VDD_2, VDD_3, and VSS may be connected to each of the plurality of semiconductor light-emitting elements 421 to 423 of the semiconductor light-emitting element package 350.

For example, the plurality of signal lines VDD_1, VDD_2, VDD_3 and VSS may comprise a first signal line VDD_1, a second signal line VDD_2, a third signal line VDD_3 and a fourth signal line VSS.

For example, the first signal line VDD_1, the second signal line VDD_2 and the third signal line VDD_3 may be disposed parallel to each other along a second direction Y. For example, the fourth signal line VSS may crossthe first signal line VDD_1, the second signal line VDD_2 and the signal line VDD_3 and be disposed along a first direction X. In this instance, a pixel PX may be defined by crossings of the first signal line VDD_1, the second signal line VDD_2, the third signal line VDD_3 and the fourth signal line VSS. Accordingly, a pixel PX may be defined for each crossing region of the first signal line VDD_1, the second signal line VDD_2, the third signal line VDD_3, and the fourth signal line VSS.

The first signal line VDD_1, the second signal line VDD_2, the third signal line VDD_3, and the fourth signal line VSS may be connected to a plurality of semiconductor light-emitting elements 421 to 423 of the semiconductor light-emitting element package 350 of each pixel PX through a plurality of connection lines 370-1 to 370-4.

The plurality of connection lines 370-1 to 370-4 may be formed after the semiconductor light-emitting element package 350 is assembled into the assembly hole 340H on the display substrate 310.

For example, the first signal line VDD_1 may be connected to a first side of the first semiconductor light-emitting element 421 via the first connection line 370-1, the second signal line VDD_2 may be connected to a first side of the second semiconductor light-emitting element 422 via the second connection line 370-2, and the third signal line VDD_3 may be connected to a first side of the third semiconductor light-emitting element 423 via the third connection line 370-3.

For example, the fourth signal line VSS may be connected to a second side of each of the first semiconductor light-emitting element 421, the second semiconductor light-emitting element 422, and the third semiconductor light-emitting element 423 via the fourth connection line 370-4.

The fourth signal line VSS may be connected to a first common pad 443, and the first common pad 443 may be commonly connected to the first semiconductor light-emitting element 421, the second semiconductor light-emitting element 422, and the third semiconductor light-emitting element 423.

For example, the first common pad 443 may be horizontally extended from the second side of the first semiconductor light-emitting element 421 onto a pair of assembling wirings 441 and 442 and connected to the pair of assembling wirings 441 and 442. The pair of assembling wirings 441 and 442 may be connected to the second semiconductor light-emitting element 422 and the third semiconductor light-emitting element 423 via a common connection electrode 450.

For example, the common connection electrode 450 may be connected to the lower side of each of the second semiconductor light-emitting element 422 and the third semiconductor light-emitting element 423. For example, the common connection electrode 450 may be in contact with the lower surface of each of the second semiconductor light-emitting element 422 and the third semiconductor light-emitting element 423. Specifically, the common connection electrode 450 may be in contact with the lower surface of each of the magnetic layers 422-1 and 423-1 of each of the second semiconductor light-emitting element 422 and the third semiconductor light-emitting element 423.

Meanwhile, since the first common pad 443 and the connection lines 370-1 to 370-4 are disposed on the upper side of each of the plurality of semiconductor light-emitting elements 421 to 423, the propagation of light of each of the plurality of semiconductor light-emitting elements 421 to 423 may be impeded. Accordingly, the first common pad 443 and the connection lines 370-1 to 370-4 may be made of a conductive material having excellent light transmittance. For example, the first common pad 443 and the connection lines 370-1 to 370-4 may comprise ITO or IZO, but are not limited thereto.

According to the first embodiment, when the first common pad 443 and the connection lines 370-1 to 370-4 are made of a transparent conductive material, the light emitted from each of the plurality of semiconductor light-emitting elements 421 to 423 does not interfere with the progress of the light, so that the light is easily emitted, thereby preventing a decrease in light efficiency.

Meanwhile, the display device 300 according to the embodiment may comprise a second signal line group 362.

The second signal line group 362 may be disposed on the other side of each of the plurality of assembly holes 340H, and may comprise a plurality of signal lines VDD_1', VDD_2', and VDD_3'. Although not illustrated, a driving transistor (DT of FIG. 3) may be connected between each of the plurality of signal lines VDD_1', VDD_2', and VDD_3' and the pixel PX.

The plurality of signal lines VDD_1', VDD_2', and VDD_3' of the second signal line group 362 may also be connected to the pixel PX. To this end, as illustrated in FIGS. 9A and 9B, the semiconductor light-emitting element package 350 may comprise a fourth semiconductor light-emitting element 424, a fifth semiconductor light-emitting element 425, and a sixth semiconductor light-emitting element 426.

The fourth semiconductor light-emitting element 424, the fifth semiconductor light-emitting element 425, and the sixth semiconductor light-emitting element 426 may emit light of different colors to display an image. For example, the fourth semiconductor light-emitting element 424 may be a red semiconductor light-emitting element, the fifth semiconductor light-emitting element 425 may be a green semiconductor light-emitting element, and the sixth semiconductor light-emitting element 426 may be a blue semiconductor light-emitting element, but are not limited thereto.

For example, the first semiconductor light-emitting element 421 and the fourth semiconductor light-emitting element 424 may each comprise a GaAs-based semiconductor material, and the second semiconductor light-emitting element 422, the third semiconductor light-emitting element 423, the fifth semiconductor light-emitting element 425, and the sixth semiconductor light-emitting element 426 may comprise a GaN-based semiconductor material, but are not limited thereto.

For example, the fifth signal line VDD_1' may be connected to the first side of the fourth semiconductor light-emitting element 424 via the fifth connection line 371-1, the sixth signal line VDD_2' may be connected to the first side of the fifth semiconductor light-emitting element 425 via the sixth connection line 371-2, and the seventh signal line VDD_3' may be connected to the first side of the sixth semiconductor light-emitting element 426 via the seventh connection line 371-3.

For example, the fourth signal line VSS may be connected to the second side of each of the fourth semiconductor light-emitting element 424, the fifth semiconductor light-emitting element 425, and the sixth semiconductor light-emitting element 426 via the fourth connection line 370-4.

Specifically, as illustrated in FIG. 7, FIG. 9A, and FIG. 9B, the fourth signal line VSS may be connected to a second common pad 444, and the second common pad 444 may be commonly connected to the fourth semiconductor light-emitting element 424, the fifth semiconductor light-emitting element 425, and the sixth semiconductor light-emitting element 426.

For example, the second common pad 444 may be horizontally extended from the second side of the fourth semiconductor light-emitting element 424 onto a pair of assembling wirings 441 and 442 and connected to a pair of assembling wirings 441 and 442. A pair of assembling wirings 441 and 442 may be connected to the fifth semiconductor light-emitting element 425 and the sixth semiconductor light-emitting element 426 via a common connection electrode 450.

For example, the common connection electrode 450 may be connected to the lower side of each of the fifth semiconductor light-emitting element 425 and the sixth semiconductor light-emitting element 426. For example, the common connection electrode 450 may be in contact with the lower surface of each of the fifth semiconductor light-emitting element 425 and the sixth semiconductor light-emitting element 426. Specifically, the common connection electrode 450 may be in contact with the lower surface of magnetic layers 425-1 and 426-1 of the fifth semiconductor light-emitting element 425 and the sixth semiconductor light-emitting element 426.

Both the first common pad 443 and the second common pad 444 may be provided, or only one of the first common pad 443 and the second common pad 444 may be provided. In addition, three or more common pads may be provided.

As will be described later, after the second semiconductor light-emitting element 422, the third semiconductor light-emitting element 423, the fifth semiconductor light-emitting element 425, and the sixth semiconductor light-emitting element 426 may be assembled on the pair of assembling wirings 441 and 442, the first common pad 443 and the second common pad 444 may be electrically connected to each of the upper portions of the pair of assembling wirings 441 and 442, and the common connection electrode 450 may be electrically connected to the lower portions of the pair of assembling wirings 441 and 442.

Meanwhile, the second semiconductor light-emitting element 422, the third semiconductor light-emitting element 423, the fifth semiconductor light-emitting element 425, and the sixth semiconductor light-emitting element 426 disposed on the pair of assembling wirings 441 and 442 may be electrically connected to the pair of assembling wirings 441 and 442.

For example, the second semiconductor light-emitting element 422 may be electrically connected to the common connection electrode 450 through a recess 430 between the pair of assembling wirings 441 and 442. For example, the third semiconductor light-emitting element 423 may be electrically connected to the common connection electrode 450 through the recess 430 between the pair of assembling wirings 441 and 442. For example, the fifth semiconductor light-emitting element 425 may be electrically connected to the common connection electrode 450 through the recess 430 between the pair of assembling wirings 441 and 442. For example, the sixth semiconductor light-emitting element 426 may be electrically connected to the common connection electrode 450 through the recess 430 between the pair of assembling wirings 441 and 442.

In addition, the first semiconductor light-emitting element 421 and the sixth semiconductor light-emitting element 426 may be electrically connected to the common connection electrode 450. For example, the lower surface of each of the first semiconductor light-emitting element 421 and the sixth semiconductor light-emitting element 426 may be in contact with the common connection electrode 450.

For example, the common connection electrode 450 may be in contact with the lower surface of the first semiconductor light-emitting element 421, and may pass through the first assembling wiring 441 of the pair of assembling wirings 441 and 442 on the lower surface of the first semiconductor light-emitting element 421, and may be in contact with the lower surface of each of the second semiconductor light-emitting element 422, the third semiconductor light-emitting element 423, the fifth semiconductor light-emitting element 425, and the sixth semiconductor light-emitting element 426 disposed on the pair of assembling wirings 441 and 442 through the recess 430 between the pair of assembling wirings 441 and 442.

For example, the common connection electrode 450 may be in contact with the lower surface of the fourth semiconductor light-emitting element 424, and may pass through the second assembling wiring 442 of the pair of assembling wirings 441 and 442 on the lower surface of the fourth semiconductor light-emitting element 424, and then contact the lower surface of each of the second semiconductor light-emitting element 422, the third semiconductor light-emitting element 423, the fifth semiconductor light-emitting element 425, and the sixth semiconductor light-emitting element 426, which are disposed on the pair of assembling wirings 441 and 442, through the recess 430 between the pair of assembling wirings 441 and 442.

The lower surface of each of the second semiconductor light-emitting element 422, the third semiconductor light-emitting element 423, the fifth semiconductor light-emitting element 425, and the sixth semiconductor light-emitting element 426, which are exposed by the gap between the pair of assembling wirings 441 and 442, may contact the common connection electrode 450.

For example, the size of the common connection electrode 450 may be the same as the size of the semiconductor light-emitting element package 350, but is not limited thereto.

In an embodiment, each of the second semiconductor light-emitting element 422, the third semiconductor light-emitting element 423, the fifth semiconductor light-emitting element 425, and the sixth semiconductor light-emitting element 426 may be a vertical-type semiconductor light-emitting element that is electrically connected from the upper side and the lower side thereof.

Meanwhile, since the second common pad 444 and the connection lines 371-1 to 371-3 are disposed on the upper side of each of the plurality of semiconductor light-emitting elements 424 to 426, Each of the plurality of semiconductor light emitting elements 424 to 426 can impede the propagation of light. Accordingly, the second common pad 444 and the connection lines 371-1 to 371-3 may be made of a conductive material having excellent light transmittance. For example, the second common pad 444 and the connection lines 371-1 to 371-3 may comprise ITO or IZO, but are not limited thereto.

According to the first embodiment, when the second common pad 444 and the connection lines 371-1 to 371-3 are made of a transparent conductive material, the light emitted from each of the plurality of semiconductor light-emitting elements 424 to 426 does not interfere with the progress of light, so that the light is easily emitted, thereby preventing a decrease in light efficiency.

Meanwhile, the plurality of semiconductor light-emitting elements 421 to 426 included in the semiconductor light-emitting element package 350 of the first embodiment may be composed of two pixels or one pixel and a dummy pixel.

As illustrated in FIG. 13, in the semiconductor light-emitting element package 350 of the first embodiment, the first to third semiconductor light-emitting elements 421 to 423 may constitute a first pixel PX1, and the fourth to sixth semiconductor light-emitting elements 424 to 426 may constitute a second pixel PX2. When the semiconductor light-emitting element package 350 illustrated in FIG. 13 is disposed in the assembly hole 340H of FIG. 7, the number of pixels is doubled by comprising two pixels PX1 and PX2 per pixel PX, so that an ultra-high-resolution display can be implemented.

That is, red light, green light and blue light are each emitted from the first to third semiconductor light-emitting elements 421 to 423 constituting the first pixel PX1 by the red data signal, the green data signal and the blue data signal applied to the first to third signal lines VDD_1 to VDD_3 included in the first signal line group 361, so that an image for the first pixel PX1 may be displayed. Red light, green light and blue light are each emitted from the fourth to sixth semiconductor light-emitting elements 424 to 426 constituting the second pixel PX2 by the red data signal, the green data signal and the blue data signal applied to the first to third signal lines VDD_1' to VDD_3' included in the second signal line group 362, so that an image for the second pixel PX2 may be displayed.

As illustrated in FIG. 14, in the semiconductor light-emitting element package 350 of the first embodiment, the first to third semiconductor light-emitting elements 421 to 423 may constitute one pixel PX, and the fourth to sixth semiconductor light-emitting elements 424 to 426 may constitute a dummy pixel PX_D. When the semiconductor light-emitting element package 350 illustrated in FIG. 14 is disposed in the assembly hole 340H illustrated in FIG. 7, the pixel PX displays an image, and the dummy pixel PX_D does not display an image.

The first to third semiconductor light-emitting elements 421 to 423 constituting the pixel PX1 may emit red light, green light, and blue light, respectively, by the red data signal, the green data signal, and the blue data signal applied to the first to third signal lines VDD_1 to VDD_3 included in the first signal line group 361, so that an image for the pixel PX1 may be displayed. The fourth to sixth semiconductor light-emitting elements 424 to 426 included in the dummy pixel PX_D may not emit light. That is, the red data signal, the green data signal, and the blue data signal are not supplied to the fourth to sixth semiconductor light-emitting elements 424 to 426 included in the dummy pixel PX_D, respectively.

When at least one or more of the first to third semiconductor light-emitting elements 421 to 423 constituting the corresponding pixel PX1 is broken and does not emit light, the broken semiconductor light-emitting element may be replaced with at least one or more of the fourth to sixth semiconductor light-emitting elements 424 to 426 constituting the dummy pixel PX_D and then used.

For example, when the second semiconductor light-emitting element 422 constituting the corresponding pixel PX1 is broken, the fifth semiconductor light-emitting element 425 emitting the same color light as the second semiconductor light-emitting element 422, i.e., green light, may be used as a replacement for the second semiconductor light-emitting element 422. To this end, by supplying the green data signal to the fifth signal line VDD_2' instead of the second signal line VDD_2, the green data signal is not supplied to the second semiconductor light-emitting element 422, but instead supplied to the fifth semiconductor light-emitting element 425, so that green light may be emitted from the fifth semiconductor light-emitting element 425.

Hereinafter, a semiconductor light-emitting element package 350 according to the first embodiment will be described with reference to FIGS. 9A, 9B, and 10A to 10D.

### [First Embodiment]

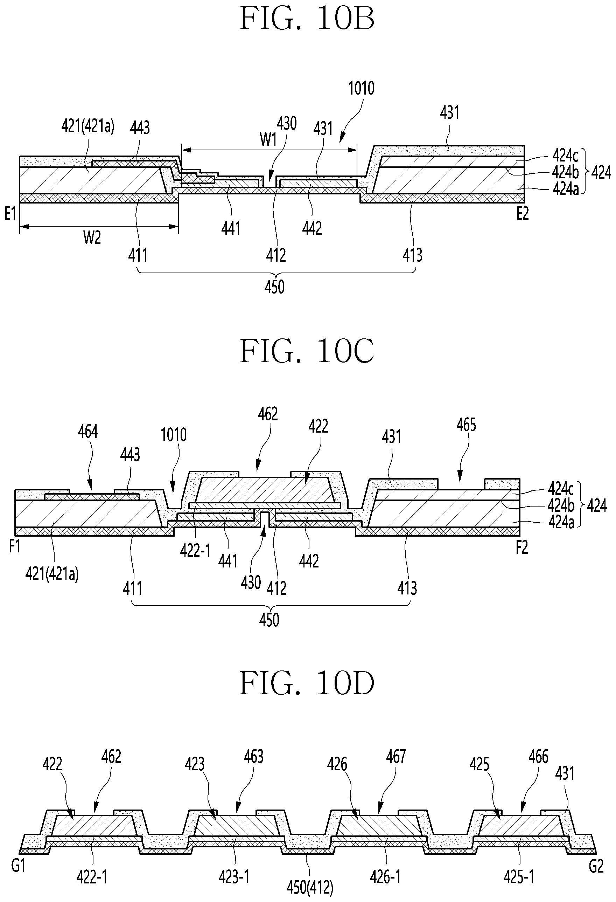

FIG. 9A is a plan view illustrating a semiconductor light-emitting element package according to the first embodiment. FIG. 9B is a bottom view illustrating a semiconductor light-emitting element package according to the first embodiment. FIG. 10A is a cross-sectional view taken along the line D1-D2 in the semiconductor light-emitting element package according to the first embodiment of FIG. 9A. FIG. 10B is a cross-sectional view taken along line E1-E2 in the semiconductor light-emitting element package according to the first embodiment of FIG. 9A. FIG. 10C is a cross-sectional view taken along line F1-F2 in the semiconductor light-emitting element package according to the first embodiment of FIG. 9A. FIG. 10D is a cross-sectional view taken along line G1-G2 in the semiconductor light-emitting element package according to the first embodiment of FIG. 9A.

Referring to FIGS. 9A to 10D, the semiconductor light-emitting element package 350 according to the first embodiment may comprise a common connection electrode 450, a first semiconductor light-emitting element 421, a pair of assembling wirings 441 and 442, a second semiconductor light-emitting element 422, and a third semiconductor light-emitting element 423.

The common connection electrode 450 may serve to support the first semiconductor light-emitting element 421, a pair of assembling wirings 441 and 442, a second semiconductor light-emitting element 422, and a third semiconductor light-emitting element 423.

The common connection electrode 450 may have a first region 411 and a second region 412. For example, the first region 411 and the second region 412 may be in contact with each other in a horizontal direction.

The first semiconductor light-emitting element 421 may be disposed on the first region 411 of the common connection electrode 450, and the pair of assembling wirings 441 and 442 may be disposed on the second region 412 of the common connection electrode 450. Accordingly, the pair of assembling wirings 441 and 442 and the first semiconductor light-emitting element 421 may be disposed horizontally with each other. That is, the pair of assembling wirings 441 and 442 and the first semiconductor light-emitting element 421 may not be vertically overlapped.

Meanwhile, the common connection electrode 450 may have a function as a supporting substrate or a supporting structure. That is, the common connection electrode 450 may serve to support various components disposed thereon, that is, the pair of assembling wirings 441 and 442, the plurality of semiconductor light-emitting elements 421 to 426, and the common pads 443 and 444.

Meanwhile, the common connection electrode 450 may comprise a reflective layer. The reflective layer may reflect light that has traveled downward from the first semiconductor light-emitting element 421 or the fourth semiconductor light-emitting element 424 upward. The reflective layer may reflect light that has traveled downward through the recess 430 between the pair of assembling wirings 441 and 442 in each of the second and third semiconductor light-emitting elements 422 and 423 or the fifth and sixth semiconductor light-emitting elements 425 and 426 upward. Therefore, the light efficiency or light output toward the front can be increased by the reflective layer to improve the luminance.

The first semiconductor light-emitting element 421 may comprise a first conductivity type semiconductor layer 421a, an active layer 421b, and a second conductivity type semiconductor layer 421c. For example, the first conductivity type semiconductor layer 421a may be an n-type semiconductor layer, and the second conductivity type semiconductor layer 421c may be a p-type semiconductor layer, but are not limited thereto. When voltage is applied to the first semiconductor light-emitting element 421, electrons may be generated in the first conductivity type semiconductor layer 421a and supplied to the active layer 421b, and holes may be generated in the second conductivity type semiconductor layer 421c and supplied to the active layer 421b. As the electrons and holes recombine in the active layer 421b, color light corresponding to a wavelength corresponding to an energy band gap of a semiconductor material of the active layer 421b may be generated. For example, the active layer 421b of the first semiconductor light-emitting element 421 may be formed of a semiconductor material that emits blue light.

Meanwhile, the common connection electrode 450 may share the first conductivity type semiconductor layer 421a of the first semiconductor light-emitting element 421. That is, the first conductivity type semiconductor layer 421a of the first semiconductor light-emitting element 421 may be used as the common connection electrode 450. Accordingly, both the first region 411 and the second region 412 of the common connection electrode 450 may be the first conductivity type semiconductor layer 421a of the first semiconductor light-emitting element 421.

In this instance, the active layer 421b and the second conductivity type semiconductor layer 421c are formed on one side region of the first conductivity type semiconductor layer 421a, that is, the first region 411 of the common connection electrode 450, so that the first semiconductor light-emitting element 421 comprising the first conductivity type semiconductor layer 421a, the active layer 421b, and the second conductivity type semiconductor layer 421c may be disposed on the first region 411 of the common connection electrode 450. In addition, a pair of assembling wirings 441 and 442 may be disposed on another region of the first conductivity type semiconductor layer 421a, that is, the second region 412 of the common connection electrode 450.

A pair of assembling wirings 441 and 442 may be used to assemble a second semiconductor light-emitting element 422 and a third semiconductor light-emitting element 423 onto a second region 412 of a common connection electrode 450 using a self-assembly method.

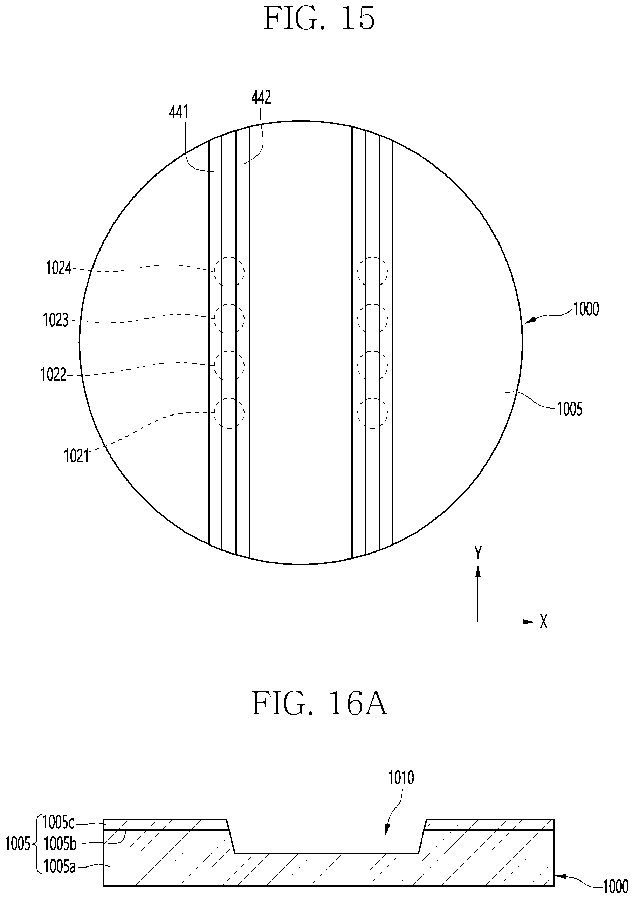

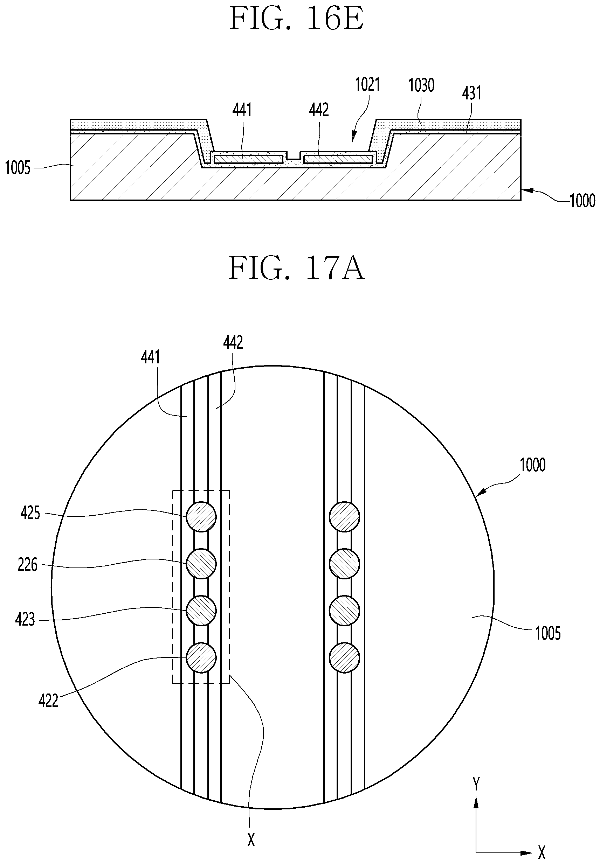

For example, a DEP force may be formed by an AC voltage applied to a pair of assembling wirings 441 and 442, and the second semiconductor light-emitting element 422 and the third semiconductor light-emitting element 423 may be assembled onto the pair of assembling wirings 441 and 442 by the DEP force. Although not illustrated in the drawing, a partition wall (1030 of FIG. 16E) comprising assembly holes (1021 to 1024 of FIG. 15) corresponding to each of the second semiconductor light-emitting element 422 and the third semiconductor light-emitting element 423 may be formed so that the second semiconductor light-emitting element 422 and the third semiconductor light-emitting element 423 may be easily assembled. The corresponding partition wall 1030 may be removed after the second semiconductor light-emitting element 422 and the third semiconductor light-emitting element 423 are assembled, but is not limited thereto.

Meanwhile, the semiconductor light-emitting element package 350 according to the first embodiment may comprise a fourth semiconductor light-emitting element 424, a fifth semiconductor light-emitting element 425, and a sixth semiconductor light-emitting element 426.

The common connection electrode 450 may have a third region 413. At this time, the second region 412 may be positioned between the first region 411 and the third region 413. Accordingly, the first region 411, the second region 412, and the third region 413 may be sequentially positioned along the horizontal direction.

The fourth semiconductor light-emitting element 424 may be disposed on the third region 413 of the common connection electrode 450. The fifth semiconductor light-emitting element 425 and the sixth semiconductor light-emitting element 426 may be disposed on a pair of assembling wirings 441 and 442.

In the self-assembly process, not only the second semiconductor light-emitting element 422 and the third semiconductor light-emitting element 423, but also the fifth semiconductor light-emitting element 425 and the sixth semiconductor light-emitting element 426 may be assembled on the pair of assembling wirings 441 and 442 by the DEP force formed on the pair of assembling wirings 441 and 442.

In the self-assembly process, the second semiconductor light-emitting element 422, the third semiconductor light-emitting element 423, the fifth semiconductor light-emitting element 425, and the sixth semiconductor light-emitting element 426 may move along the magnet. In this instance, in order to enhance the mobility of each of the second semiconductor light-emitting element 422, the third semiconductor light-emitting element 423, the fifth semiconductor light-emitting element 425, and the sixth semiconductor light-emitting element 426, the second semiconductor light-emitting element 422, the third semiconductor light-emitting element 423, the fifth semiconductor light-emitting element 425, and the sixth semiconductor light-emitting element 426 may comprise magnetic layers 422-1, 423-1, 425-1, and 426-1, respectively. The magnetic layer 422-1, 423-1, 425-1, and 426-1 may comprise nickel, cobalt, etc., but is not limited thereto. For example, the magnetic layer 422-1, 423-1, 425-1 and 426-1 may be provided on the lower side of each of the second semiconductor light-emitting element 422, the third semiconductor light-emitting element 423, the fifth semiconductor light-emitting element 425 and the sixth semiconductor light-emitting element 426, but is not limited thereto.

Although not illustrated in the drawing, a partition wall 1030 comprising an assembly hole (1021 to 1024 in FIG. 15) corresponding to each of the fifth semiconductor light-emitting element 425 and the sixth semiconductor light-emitting element 426 may be formed so that the fifth semiconductor light-emitting element 425 and the sixth semiconductor light-emitting element 426 may be easily assembled. The partition wall 1030 may be removed after the fifth semiconductor light-emitting element 425 and the sixth semiconductor light-emitting element 426 are assembled, but is not limited thereto.

Meanwhile, the fourth semiconductor light-emitting element 424 may comprise a first conductivity type semiconductor layer 424a, an active layer 424b, and a second conductivity type semiconductor layer 424c. The first conductivity type semiconductor layer 424a may be an n-type semiconductor layer, and the second conductivity type semiconductor layer 424c may be a p-type semiconductor layer, but are not limited thereto.

The first conductivity type semiconductor layer 424a of the fourth semiconductor light-emitting element 424 may be connected to the first conductivity type semiconductor layer 421a of the first semiconductor light-emitting element 421. That is, the first conductivity type semiconductor layer 424a of the fourth semiconductor light-emitting element 424 and the first conductivity type semiconductor layer 421a of the first semiconductor light-emitting element 421 may be formed integrally. Accordingly, the first conductivity type semiconductor layer 421a of the first semiconductor light-emitting element 421 or the first conductivity type semiconductor layer 424a of the fourth semiconductor light-emitting element 424 may be used as the first region 411, the second region 412, and the third region 413 of the common connection electrode 450.

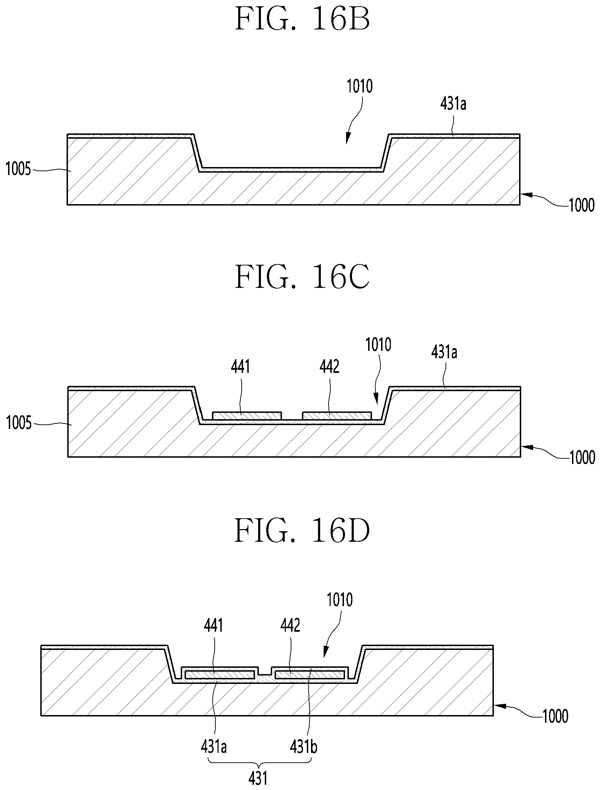

For example, the active layer 421b and the second conductivity type semiconductor layer 421c of the first semiconductor light-emitting element 421 or the active layer 424b and the second conductivity type semiconductor layer 424c of the fourth semiconductor light-emitting element 424 may be not disposed on the second region 412 of the common connection electrode 450. Accordingly, a recess (1010 of FIG. 16C or FIG. 16D) may be formed on the second region 412 of the common connection electrode 450.

For example, the second semiconductor light-emitting element 422, the third semiconductor light-emitting element 423, the fifth semiconductor light-emitting element 425, and the sixth semiconductor light-emitting element 426 may be disposed between the first semiconductor light-emitting element 421 and the fourth semiconductor light-emitting element 424. For example, the third semiconductor light-emitting element 423 and the sixth semiconductor light-emitting element 426 may be disposed between the second semiconductor light-emitting element 422 and the fifth semiconductor light-emitting element 425.

The first semiconductor light-emitting element 421 and the fourth semiconductor light-emitting element 424 may be symmetrical to each other with respect to the center of the semiconductor light-emitting element package 350. The second semiconductor light-emitting element 422 and the fifth semiconductor light-emitting element 425 may be symmetrical to each other with respect to the center of the semiconductor light-emitting element package 350. The third semiconductor light-emitting element 423 and the sixth semiconductor light-emitting element 426 may be symmetrical to each other with respect to the center of the semiconductor light-emitting element package 350.

The second semiconductor light-emitting element 422, the third semiconductor light-emitting element 423, the fifth semiconductor light-emitting element 425, and the sixth semiconductor light-emitting element 426 may be disposed on a pair of assembling wirings 441 and 442. For example, the second semiconductor light-emitting element 422, the third semiconductor light-emitting element 423, the fifth semiconductor light-emitting element 425, and the sixth semiconductor light-emitting element 426 may be simultaneously self-assembled on the pair of assembling wirings 441 and 442 by the DEP force formed on the pair of assembling wirings 441 and 442.

For example, the third semiconductor light-emitting element 423 and the sixth semiconductor light-emitting element 426 may be disposed between the second semiconductor light-emitting element 422 and the fifth semiconductor light-emitting element 425. Accordingly, the second semiconductor light-emitting element 422, the third semiconductor light-emitting element 423, the sixth semiconductor light-emitting element 426, and the fifth semiconductor light-emitting element 425 may be disposed in the order along the length direction of the pair of assembling wirings 441 and 442, i.e., the Y direction.

Meanwhile, the unexplained reference numerals 461 to 468 may be contact holes. Through these contact holes 461 to 468, a plurality of connection lines 370-1 to 370-4 and 371-1 to 371-3 may be connected to a plurality of semiconductor light-emitting elements 421 to 426 of the semiconductor light-emitting element package 350.

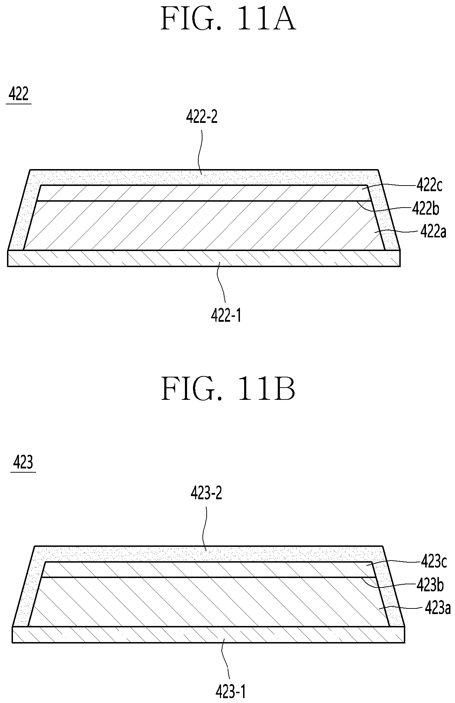

Meanwhile, as illustrated in FIGS. 11A and 11B , the second semiconductor light-emitting element 422 and the third semiconductor light-emitting element 423 may be pre-made semiconductor light-emitting elements, i.e., chips. Although not illustrated, the fifth semiconductor light-emitting element 425 and the sixth semiconductor light-emitting element 426 may also be pre-made chips. These second semiconductor light-emitting elements 422, third semiconductor light-emitting elements 423, fifth semiconductor light-emitting elements 425 and sixth semiconductor light-emitting elements 426 may be self-assembled on a pair of assembling wirings 441 and 442 by a DEP force formed by a pair of assembling wirings 441 and 442.

The second semiconductor light-emitting element 422 may comprise a first conductivity type semiconductor layer 422a, an active layer 422b and a second conductivity type semiconductor layer 422c. The third semiconductor light-emitting element 423 may comprise a first conductivity type semiconductor layer 423a, an active layer 423b and a second conductivity type semiconductor layer 423c. The second semiconductor light-emitting element 422 may comprise a magnetic layer 422-1 under the first conductivity type semiconductor layer 422a and a passivation layer 422-2 surrounding the first conductivity type semiconductor layer 422a, the active layer 422b, and the second conductivity type semiconductor layer 422c. Similarly, the second semiconductor light-emitting element 423 may comprise a magnetic layer 423-1 under the first conductivity type semiconductor layer 423a and a passivation layer 423-2 surrounding the first conductivity type semiconductor layer 423a, the active layer 423b, and the second conductivity type semiconductor layer 423c.

In addition, the second semiconductor light-emitting element 422 and the third semiconductor light-emitting element 423 may comprise the magnetic layers 422-1 and 423-1, respectively. The magnetic layer 422-1 may be disposed under the first conductivity type semiconductor layer 422a of the second semiconductor light-emitting element 422, and the magnetic layer 423-1 may be disposed under the first conductivity type semiconductor layer 423a of the third semiconductor light-emitting element 423. When self-assembling, the magnetic layers 422-1 and 423-1 of the second semiconductor light-emitting element 422 and the third semiconductor light-emitting element 423, respectively, may be magnetized by the magnet, so that the second semiconductor light-emitting element 422 and the third semiconductor light-emitting element 423 can be easily moved by the movement of the magnet, and thus the assembly speed of the second semiconductor light-emitting element 422 and the third semiconductor light-emitting element 423, respectively, can be improved.

Similarly, the fifth semiconductor light-emitting element 425 and the sixth semiconductor light-emitting element 426 may comprise a magnetic layer (not illustrated), respectively.

Meanwhile, the semiconductor light-emitting element package 350 according to the first embodiment may comprise a first common pad 443 and a second common pad 444. Since the first common pad 443 and the second common pad 444 are disposed on the first to sixth semiconductor light-emitting elements 421 to 426, they may be made of a transparent conductive material so as not to obstruct the forward propagation of the corresponding lights.

For example, the first common pad 443 may be commonly connected to a first side of each of the first semiconductor light-emitting element 421, the second semiconductor light-emitting element 422, and the third semiconductor light-emitting element 423, and the second common pad 444 may be commonly connected to a first side of each of the fourth semiconductor light-emitting element 424, the fifth semiconductor light-emitting element 425, and the sixth semiconductor light-emitting element 426.

Current of each of the first semiconductor light-emitting element 421, the second semiconductor light-emitting element 422, and the third semiconductor light-emitting element 423 may flow to the fourth signal line VSS through the first common pad 443. Current of each of the fourth semiconductor light-emitting element 424, the fifth semiconductor light-emitting element 425, and the sixth semiconductor light-emitting element 426 may flow to the fourth signal line VSS through the second common pad 444.

The first common pad 443 may extend from the third semiconductor light-emitting element 423 to the first semiconductor light-emitting element 421 via the second semiconductor light-emitting element 422. The second common pad 444 may extend from the sixth semiconductor light-emitting element 426 to the fourth semiconductor light-emitting element 424 via the fifth semiconductor light-emitting element 425.

The first common pad 443 and the second common pad 444 may be positioned diagonally based on the center of the semiconductor light-emitting element package 350.

Meanwhile, the semiconductor light-emitting element package 350 according to the first embodiment may comprise an insulating layer 431.

The insulating layer 431 may serve to insulate various components disposed on the common connection electrode 450. The insulating layer 431 may be composed of a plurality of layers, but is not limited thereto. The plurality of layers may be made of the same insulating material, but are not limited thereto.

The insulating layer 431 may be formed around each of the second semiconductor light-emitting element 422, the third semiconductor light-emitting element 423, the fifth semiconductor light-emitting element 425, and the sixth semiconductor light-emitting element 426. The insulating layer 431 may firmly fix each of the second semiconductor light-emitting element 422, the third semiconductor light-emitting element 423, the fifth semiconductor light-emitting element 425, and the sixth semiconductor light-emitting element 426 to the common connection electrode 450.

The insulating layer 431 may be formed on the first to sixth semiconductor light-emitting elements 421 to 426. The insulating layer 431 may protect the first to sixth semiconductor light-emitting elements 421 to 426 from an electrical short caused by an external impact or an external foreign substance.

Meanwhile, in the semiconductor light-emitting element package 350 according to the first embodiment, a plurality of semiconductor light-emitting elements 422, 423, 425, and 426 may be assembled into the assembly hole 340H illustrated in FIGS. 7 and 8 using a self-assembly process.

Since the semiconductor light-emitting element package 350 of the first embodiment is provided with a plurality of semiconductor light-emitting elements 421 to 426, it may not be easy for the semiconductor light-emitting element package 350 to be moved by a magnet during the self-assembly process.

Therefore, in order to enhance the mobility of the semiconductor light-emitting element package 350, a pair of assembling wirings 441 and 442 and/or a common connection electrode 450 of the semiconductor light-emitting element package 350 may comprise at least two or more metal layers comprising at least a magnetic layer. The larger the area of the magnetic layer, the greater the magnetization characteristics. To this end, the total width W1 of the pair of assembled wirings 441 and 442 may be greater than the width W2 of the first semiconductor light-emitting element 421 or the fourth semiconductor light-emitting element 424. In addition, a size of the common connection electrode 450 may be the same as a size of the semiconductor light-emitting element package 350 according to the first embodiment.

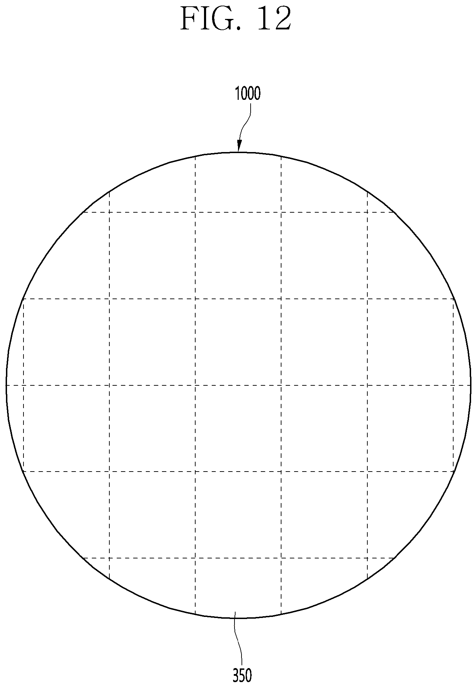

Meanwhile, the semiconductor light-emitting element package 350 according to the first embodiment may be manufactured on the wafer 1000 illustrated in FIG. 12.

That is, an epitaxial layer (1005 of FIGS. 16A to 16E) for forming the first semiconductor light-emitting element 421 or the fourth semiconductor light-emitting element 424 may be formed on the wafer 1000, and an upper side of the epitaxial layer 1005 may be etched to form a recess 1010. A pair of assembling wirings 441 and 442 may be formed in the recess 1010, and a second semiconductor light-emitting element 422, a third semiconductor light-emitting element 423, a fifth semiconductor light-emitting element 425, and a sixth semiconductor light-emitting element 426 may be assembled using a self-assembly process. Thereafter, a first semiconductor light-emitting element 421 and a fourth semiconductor light-emitting element 424 formed in the epitaxial layer 1005 may be manufactured through a series of post-processes, and a second semiconductor light-emitting element 422, a third semiconductor light-emitting element 423, a fifth semiconductor light-emitting element 425, and a sixth semiconductor light-emitting element 426 may be formed on the recess 1010. Thereafter, a plurality of package regions corresponding to a plurality of semiconductor light-emitting element packages 350, respectively, may be partitioned, and after the plurality of package regions may be separated from the wafer 1000 through a separation process, a common connection electrode may be formed on the back surface of each of the package regions, so that a plurality of semiconductor light-emitting element packages 350 may be manufactured.

### [Manufacturing process of semiconductor light-emitting element package]

FIGS. 15 to 28 illustrate a manufacturing process of a semiconductor light-emitting element package according to the first embodiment.

Referring to FIG. 15, first, a plurality of holes 1021 to 1024 may be formed along a second direction Y on a wafer 1000.

Specifically, as illustrated in FIG. 16A, an epitaxial layer 1005 may be formed on the wafer 1000. The epitaxial layer 1005 may comprise a plurality of semiconductor layers 1005a, 1005b, and 1005c. The plurality of semiconductor layers may comprise a first semiconductor layer 1005a, a second semiconductor layer 1005b, and a third semiconductor layer 1005c. The first semiconductor layer 1005a, the second semiconductor layer 1005b, and the third semiconductor layer 1005c may comprise multiple layers, respectively.

For example, the wafer 1000 may support the epitaxial layer 1005, and may also be a member that facilitates the deposition of the epitaxial layer 1005, such as a sapphire substrate, a semiconductor substrate, or a ceramic substrate.

For example, the first semiconductor layer 1005a may be a first conductivity type semiconductor layer and may comprise a first conductivity type dopant. For example, the second semiconductor layer 1005b may be an active layer and may generate light. Light having a wavelength corresponding to a band gap of a semiconductor material of the active layer 1005b may be generated. For example, the third semiconductor layer 1005c may be a second conductivity type semiconductor layer and may comprise a second conductivity type dopant. The first conductivity type dopant may be an n-type dopant, and the second conductivity type dopant may be a p-type dopant, but are not limited thereto.

The first semiconductor layer 1005a, the second semiconductor layer 1005b, and the third semiconductor layer 1005c may be sequentially deposited on the wafer 1000 using a deposition device, such as an MOCVD deposition device.

Meanwhile, the recess 1010 may be formed by etching an upper surface of the epitaxial layer 1005 inwardly along the second direction Y. That is, the third semiconductor layer 1005c and the second semiconductor layer 1005b of the epitaxial layer 1005 may be removed, and a part of the upper surface of the first semiconductor layer 1005a may be removed, so that the recess 1010 may be formed. Therefore, the depth of the recess 1010 may be the sum of a thickness of the third semiconductor layer 1005c, a thickness of the second semiconductor layer 1005b, and a thickness of the first semiconductor layer 1005a with a part of the upper surface thereof removed.

Even if the recess 1010 is formed, the epitaxial layer 1005 may be connected to each other through the recess 1010. That is, since a bottom portion of the recess 1010 is the first semiconductor layer 1005a of the epitaxial layer 1005, the first semiconductor layers 1005a of the epitaxial layer 1005 corresponding to the left and right sides of the recess 1010 may be connected to each other through the first semiconductor layer 1005a under the recess 1010. The first semiconductor layer 1005a of the epitaxial layer 1005 on the left side of the recess 1010 may be defined as a first region 411, the first semiconductor layer 1005a of the epitaxial layer 1005 under the recess 1010 may be defined as a second region 412, and the first semiconductor layer 1005a of the epitaxial layer 1005 on the right side of the recess 1010 may be defined as a third region 413.

As illustrated in FIG. 16B, an insulating layer 431a may be formed on the epitaxial layer 1005. Since the epitaxial layer 1005 comprises a dopant, the insulating layer 431a may be formed to insulate the epitaxial layer 1005.

As illustrated in FIG. 16C, a pair of assembling wirings 441 and 442 may be formed in the recess 1010. For example, a metal film may be deposited on the insulating layer 431a and then patterned, thereby forming a pair of assembling wirings 441 and 442 in the recess 1010. The pair of assembling wirings 441 and 442 may be formed to be long along the second direction Y. The pair of assembling wirings 441 and 442 may be made of a metal having excellent electrical conductivity. The pair of assembling wirings 441 and 442 may each comprise a magnetic layer that may be easily magnetized by a magnet.

As illustrated in FIG. 16D, another insulating layer 431b may be formed on the pair of assembling wirings 441 and 442 and the insulating layer 431a. The insulating layer 431a and the other insulating layer 431b may be formed of the same insulating material. Accordingly, the insulating layer 431 may be formed by the insulating layer 431a and the other insulating layer 431b. Accordingly, an electrical short between a pair of assembling wirings 441 and 442 and the epitaxial layer 1005 can be prevented by the insulating layer 431, and the epitaxial layer 1005 can be protected from external foreign substances.

As illustrated in FIG. 16E, a partition wall 1030 may be formed on the insulating layer 431. Since the partition wall 1030 is formed with a relatively thick thickness, it may be formed of an organic material, but is not limited thereto.

As illustrated in FIG. 15, the partition wall 1030 may comprise a plurality of assembly holes 1021 to 1024. The plurality of assembly holes 1021 to 1024 may be positioned on a pair of assembling wirings 441 and 442 within the recess 1010.

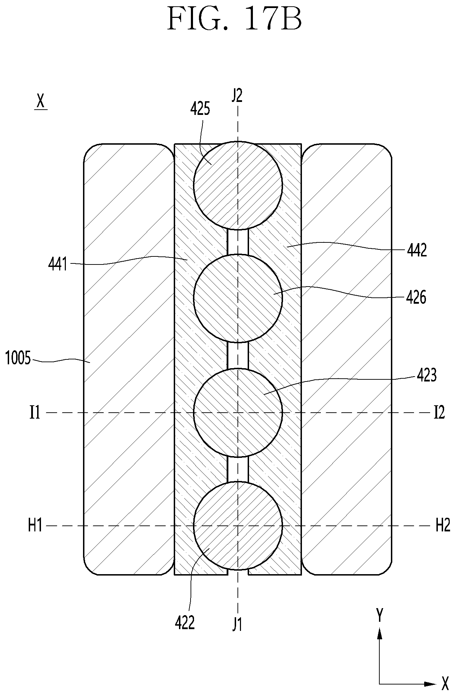

Meanwhile, referring to FIGS. 17A and 17B, a plurality of semiconductor light-emitting elements 422, 423, 425, and 426 may be assembled on a pair of assembling wirings 441 and 442 using self-assembly.

Specifically, after the wafer 1000 is mounted in a chamber filled with a fluid (not illustrated) for self-assembly, a DEP force may be formed by an AC voltage applied to the pair of assembling wirings 441 and 442. As the magnet moves, the plurality of semiconductor light-emitting elements 422, 423, 425, and 426 within the fluid may move. A plurality of semiconductor light-emitting elements 422, 423, 425, and 426 may be moved in a fluid and then assembled into a plurality of assembly holes 1021 to 1024 on a wafer 1000. That is, since a DEP force formed by a pair of assembling wirings 441 and 442 is formed in each of the plurality of assembly holes 1021 to 1024, the plurality of semiconductor light-emitting elements 422, 423, 425, and 426 may be assembled into the plurality of assembly holes 1021 to 1024, respectively, by the DEP force.

It is illustrated in the drawing that the plurality of semiconductor light-emitting elements 422, 423, 425, and 426 have the same shape, but is not limited thereto.

For example, the plurality of semiconductor light-emitting elements 422, 423, 425, and 426 may have different shapes from each other. For example, the second semiconductor light-emitting element 422 and the fifth semiconductor light-emitting element 425 that emit green light may have a square shape, and the third semiconductor light-emitting element 423 and the sixth semiconductor light-emitting element 426 that emit blue light may have a circular shape. For example, the second semiconductor light-emitting element 422 and the fifth semiconductor light-emitting element 425 that emit green light may have a circular shape, and the third semiconductor light-emitting element 423 and the sixth semiconductor light-emitting element 426 that emit blue light may have an oval shape. In this way, since the plurality of semiconductor light-emitting elements 422, 423, 425, and 426 have different shapes, even if the plurality of semiconductor light-emitting elements 422, 423, 425, and 426 are mixed in a fluid within the chamber, they may be simultaneously assembled on a pair of assembling wirings 441 and 442 without assembly defects.

Meanwhile, the plurality of assembly holes (1021 to 1024 in FIG. 15) may have different shapes. For example, when the second semiconductor light-emitting element 422 and the fifth semiconductor light-emitting element 425 have a square shape, the corresponding assembly holes 1021 and 1024 may also have a square shape. For example, when the third semiconductor light-emitting element 423 and the sixth semiconductor light-emitting element 426 have a circular shape, the corresponding assembly holes 1022 and 1023 may also have a circular shape.

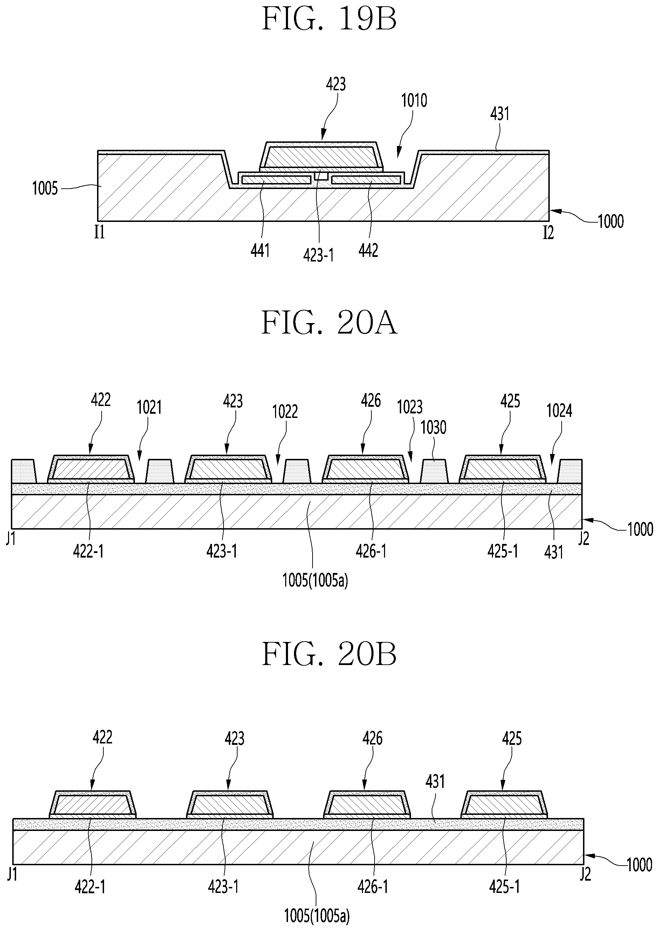

Each of the plurality of semiconductor light-emitting elements 422, 423, 425, and 426 may be a pre-manufactured component. That is, each of the plurality of semiconductor light-emitting elements 422, 423, 425, and 426 may be manufactured using a series of semiconductor processes. Each of the plurality of semiconductor light-emitting elements 422, 423, 425, and 426 may comprise a first conductivity type semiconductor layer (not illustrated), an active layer (not illustrated), a second conductivity type semiconductor layer (not illustrated), and a magnetic layer (422-1, 423-1, 425-1, 426-1 of FIG. 20A).

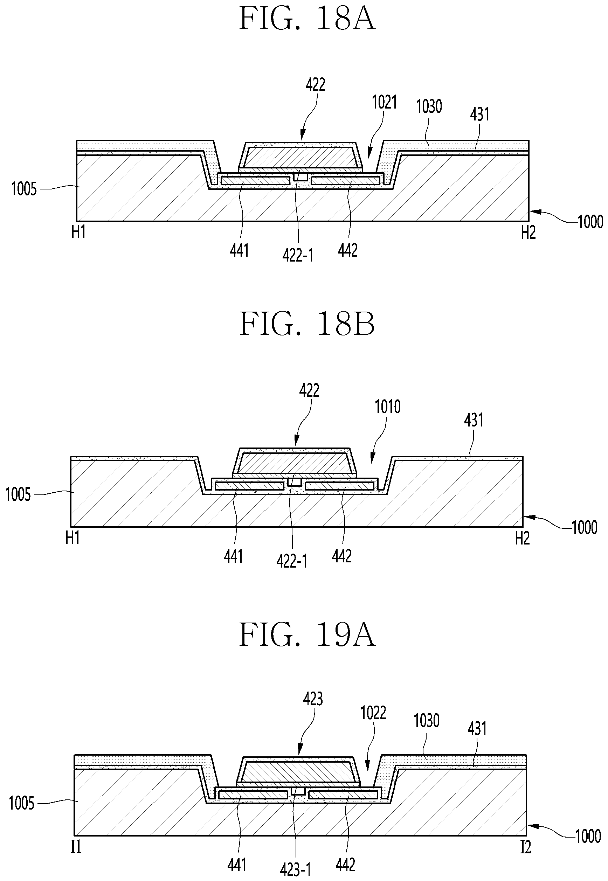

First, as illustrated in FIG. 18A, FIG. 19A, and FIG. 20A, the plurality of semiconductor light-emitting elements 422, 423, 425, and 426 may be assembled into the plurality of assembly holes 1021 to 1024, respectively, by a DEP force formed on a pair of assembling wirings 441 and 442.

Thereafter, as illustrated in FIG. 18B, FIG. 19B and FIG. 20B, by spraying the polymer and then removing it, each of the plurality of semiconductor light-emitting elements 422, 423, 425 and 426 may be attached to the insulating layer 431 by the polymer. Instead of the polymer, another material may be used. When the polymer is removed, the partition wall 1030 may also be removed together, but is not limited thereto.

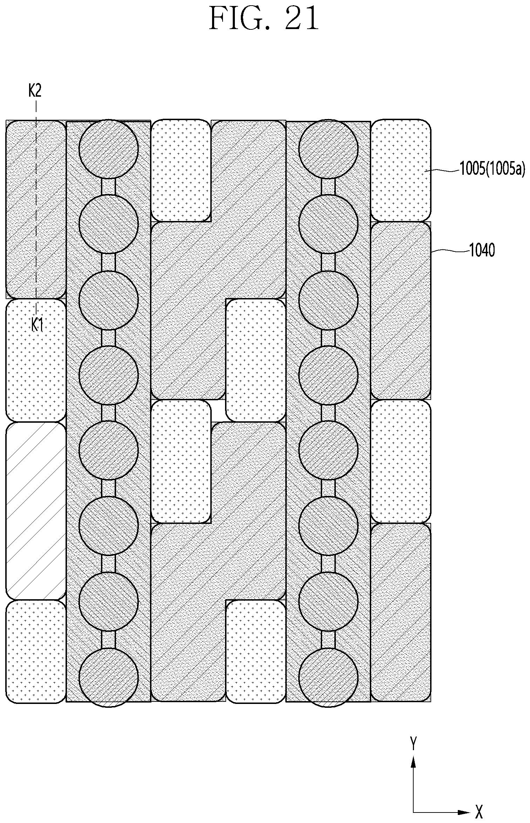

Meanwhile, referring to FIG. 21, by partially patterning using the mask 1040, the first semiconductor layer 1005a, i.e., the first conductivity type semiconductor layer, may be exposed in the epitaxial layer 1005.

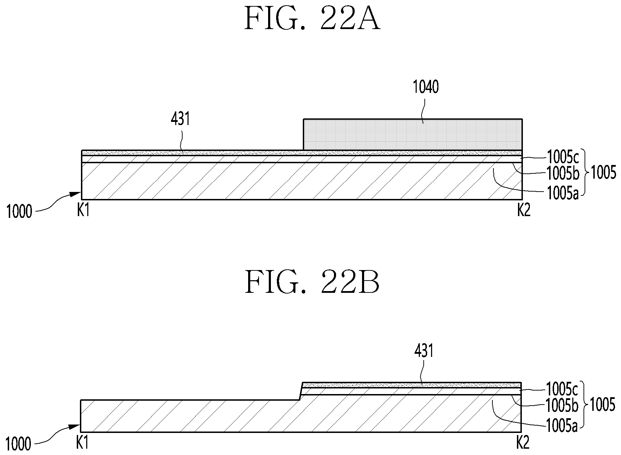

Specifically, as illustrated in FIG. 22A, after a part of the epitaxial layer 1005 is blocked by the mask 1040, as illustrated in FIG. 22B, the third semiconductor layer 1005c and the second semiconductor layer 1005b of the epitaxial layer 1005, which are not blocked by the mask 1040, may be removed to expose the first semiconductor layer 1005a. A part of an upper surface of the first semiconductor layer 1005a may also be removed, but is not limited thereto. Thereafter, the mask 1040 may be removed.

As illustrated in FIG. 21, the third semiconductor layer 1005c and the second semiconductor layer 1005b may be removed from some regions of the epitaxial layer 1005 positioned on each of both sides of the second semiconductor light-emitting element 422, the third semiconductor light-emitting element 423, the fifth semiconductor light-emitting element 425, and the sixth semiconductor light-emitting element, so that the first semiconductor layer 1005a may be exposed.

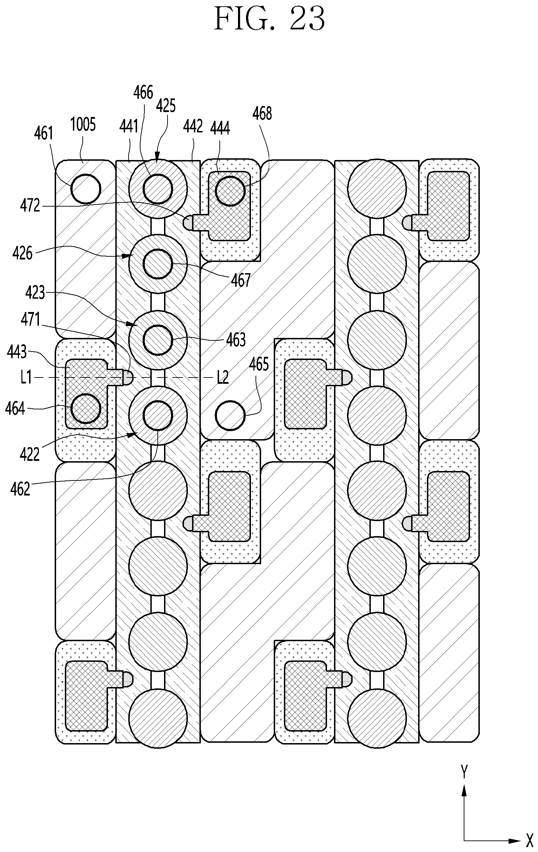

Meanwhile, referring to FIG. 23, a first common pad 443 and a second common pad 444 may be formed.

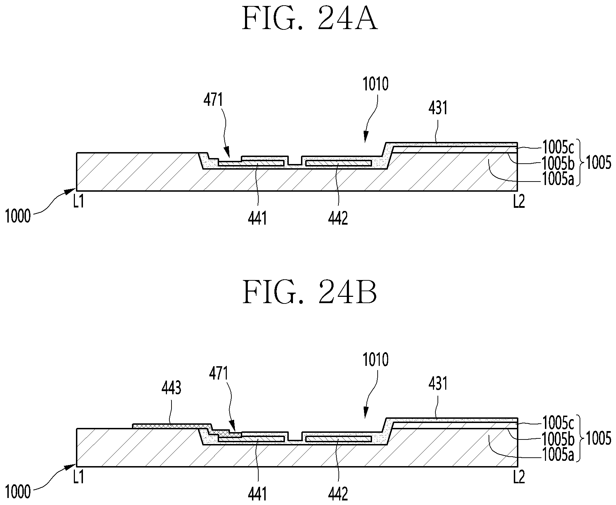

Specifically, as illustrated in FIG. 24A, the first semiconductor layer 1005a may be exposed from some regions of the epitaxial layer 1005.

Meanwhile, an insulating film 431 may be patterned on the first assembling wiring 441, so that a contact hole 471 may be formed to expose an upper surface of the first assembling wiring 441.

Thereafter, a conductive film may be formed and patterned on the wafer 1000, so that a first common pad 443 may be formed. The first common pad 443 may electrically connect the first semiconductor layer 1005a of the epitaxial layer 1005 and the first assembling wiring 441. That is, one side of the first common pad 443 may be positioned on the first semiconductor layer 1005a of the epitaxial layer 1005, and the other side of the first common pad 443 may be positioned on the first assembling wiring 441. For example, the first common pad 443 may extend along the first direction X from the first semiconductor layer 1005a of the epitaxial layer 1005 and may be connected to the first assembling wiring 441 through the contact hole 471.

Likewise, the second common pad 444 may also be formed by the same method as the method of forming the first common pad 443 described above.

Meanwhile, although not illustrated, a plurality of contact holes 461 to 468 may be formed. For example, the contact holes 462, 463, 466, and 467 may be formed on the second semiconductor light-emitting element 422, the third semiconductor light-emitting element 423, the fifth semiconductor light-emitting element 425, and the sixth semiconductor light-emitting element 426, respectively. For example, the contact holes 464 and 468 may be formed on the first and second common pads 443 and 444, respectively. For example, the contact holes 461 and 465 may be formed on the epitaxial layer 1005 on both sides of a pair of assembling wirings 441 and 442. These contact holes 461 to 468 may be formed by removing the insulating layer 431.

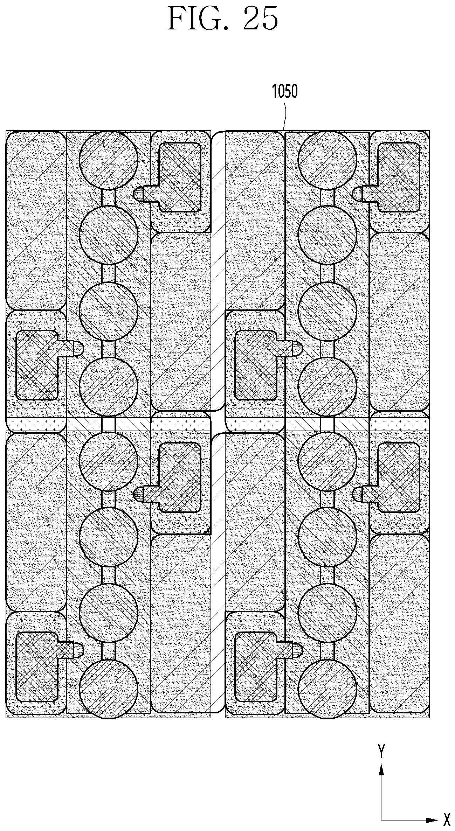

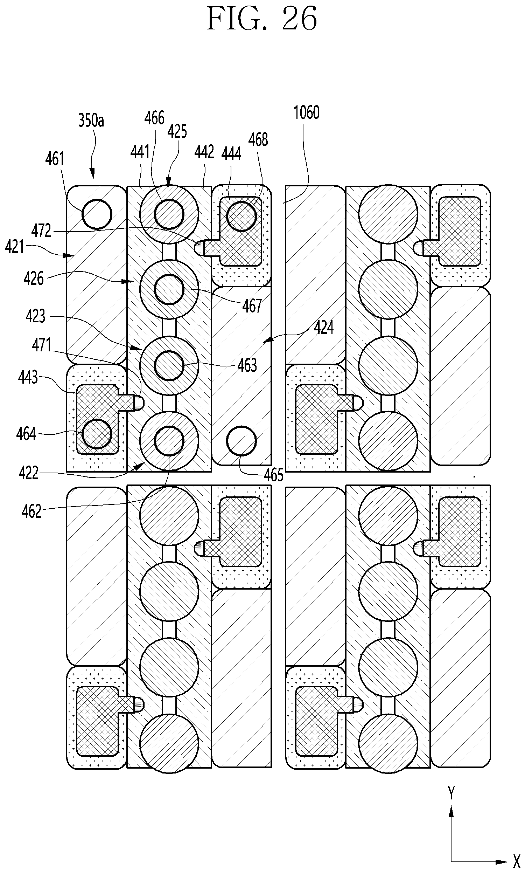

Meanwhile, referring to FIGS. 25 and 26, the epitaxial layer 1005 may be patterned using a mask 1050 to form package regions 350a for forming a plurality of semiconductor light-emitting element packages 350 on the wafer 1000, respectively.

All layers of the epitaxial layer 1005, i.e., the first semiconductor layer 1005a, the second semiconductor layer 1005b, and the third semiconductor layer 1005c, may be removed along the perimeter of each of the package regions 350a. By removing the first semiconductor layer 1005a, the second semiconductor layer 1005b, and the third semiconductor layer 1005c, the upper surface of the wafer 1000, for example, the sapphire substrate, may be exposed. By removing the first semiconductor layer 1005a, the second semiconductor layer 1005b, and the third semiconductor layer 1005c, a recess 1060 may be formed between the package regions 350a.

As will be described later, by forming a common connection electrode 450 on a lower side of each of the package regions 350a separated from the wafer 1000, the package regions 350a may become a plurality of semiconductor light-emitting element packages 350, respectively.

Meanwhile, each of the package regions 350a may comprise first to sixth semiconductor light-emitting elements 421 to 426, a pair of assembling wirings 441 and 442, a first common pad 443, and a second common pad 443.

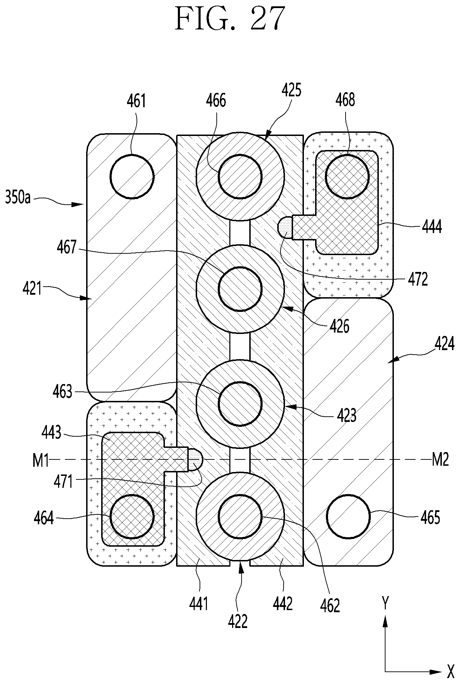

Meanwhile, referring to FIG. 27, each of the pad regions 350a may be separated from the wafer 1000. For example, by irradiating a laser to a boundary surface between the epitaxial layer 1005 and the wafer 1000, each of the pad regions 350a may be separated from the wafer 1000, but is not limited thereto.

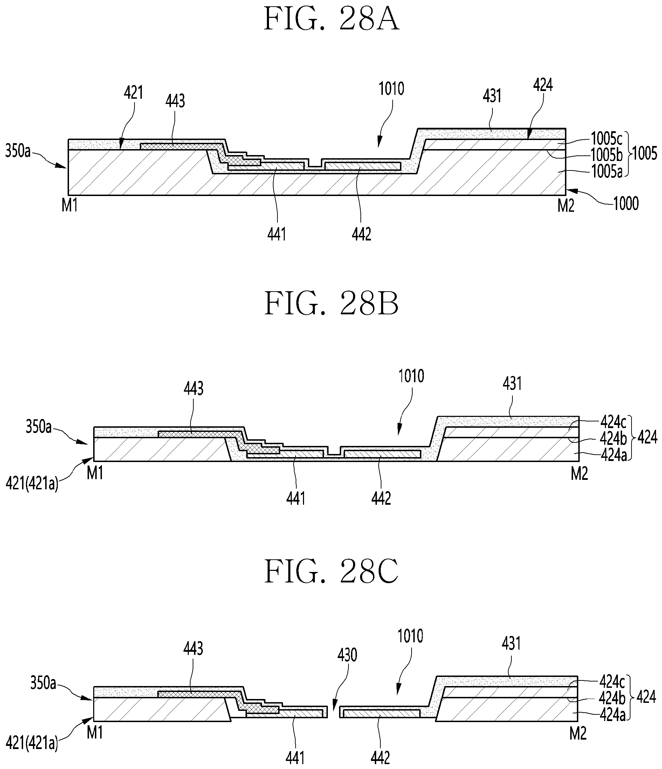

Thereafter, a common connection electrode 450 may be formed on a lower side of each of the pad regions 350a, so that a semiconductor light-emitting element package 350 may be manufactured (FIGS. 28A to 28D).

Specifically, as illustrated in FIG. 28A, the package region 350a may be separated from the wafer 1000.

As illustrated in FIG. 28B, the first semiconductor layer 1005a of the epitaxial layer 1005 may be etched so that the insulating layer 431 under the pair of assembling wirings 441 and 442 is exposed. That is, the etching process of the first semiconductor layer 1005a may be performed until the insulating layer 431 is exposed.

In this way, even if the first semiconductor layer 1005a is removed by the etching process until the insulating layer 431 is exposed, a part of the first semiconductor layer 1005a may remain. Accordingly, the epitaxial layer 1005 may be formed as the first semiconductor light-emitting element 421 and the fourth semiconductor light-emitting element 424, respectively, by the first semiconductor layer 1005a, the second semiconductor layer 1005b, and the third semiconductor layer 1005c. In this instance, the first semiconductor layer 1005a may become the first conductivity type semiconductor layer 421a and 424a of the first and fourth semiconductor light-emitting elements 421 and 424, respectively, the second semiconductor layer 1005b may become the active layer 421b and 424b of the first and fourth semiconductor light-emitting elements 421 and 424, respectively, and the third semiconductor layer 1005c may become the second conductivity type semiconductor layer 421c and 424c of the first and fourth semiconductor light-emitting elements 421 and 424, respectively.

As illustrated in FIG. 28C, the insulating layer 431 under the pair of assembling wirings 441 and 442 may be etched so that the pair of assembling wirings 441 and 442 may be exposed. Accordingly, a recess 430 may be formed between the pair of assembling wirings 441 and 442, in which the insulating layer 431 is spaced apart. The insulating layer 431 can be penetrated vertically by the recess 430.

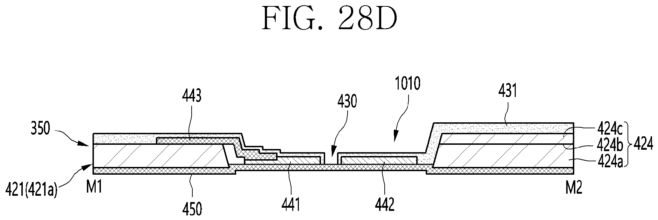

As illustrated in FIG. 28D, a metal film may be deposited on the lower side of the package region 350a, so that a common connection electrode 450 may be formed.

For example, the common connection electrode 450 may be in contact with the lower surface of the first conductivity type semiconductor layer 421a of the first semiconductor light-emitting element 421 and may be in contact with the lower surface of the first conductivity type semiconductor layer 424a of the fourth semiconductor light-emitting element 424.

For example, the common connection electrode 450 may be in contact with the lower surface of each of the pair of assembling wirings 441 and 442.

For example, the common connection electrode 450 may be in contact with the lower surface of each of the second semiconductor light-emitting element 422, the third semiconductor light-emitting element 423, the fifth semiconductor light-emitting element 425, and the sixth semiconductor light-emitting element 426 through the recess 430 between the pair of assembling wirings 441 and 442. Specifically, the common connection electrode 450 may contact a lower side of the first conductivity type semiconductor layer (not illustrated) of the second semiconductor light-emitting element 422, a lower side of the first conductivity type semiconductor layer (not illustrated) of the third semiconductor light-emitting element 423, a lower side of the first conductivity type semiconductor layer (not illustrated) of the fifth semiconductor light-emitting element 425, and a lower side of the first conductivity type semiconductor layer (not illustrated) of the sixth semiconductor light-emitting element 426, respectively, through the recess 430 between the pair of assembling wirings 441 and 442.

For example, the first to sixth semiconductor light-emitting elements 421 to 426 may be connected by the common connection electrode 450. In addition, the first common pad 443 may be connected to one side of the first assembling wiring 441 among the pair of common electrodes 441 and 442, the second common pad 443 may be connected to one side of the second assembling wiring 442 among the pair of common electrodes 441 and 442, and the common connection electrode 450 may be connected to the other side of each of the pair of assembling wirings 441 and 442.

Meanwhile, one side of the first to sixth semiconductor light-emitting elements 421 to 426 may be connected to a plurality of connection lines (370-1 to 370-3 and 371-1 to 361-3 in FIG. 7) through a plurality of contact holes 461 to 463 and 465 to 467, respectively. The other side of the first to sixth semiconductor light-emitting elements 421 to 426 may be connected to a connection line 370-4 via a common connection electrode 450, a pair of assembling wirings 441 and 442, and the first and second common pads 443 and 444. For example, the connection line 370-4 may be connected to the first and second common pads 443 and 444 through the contact holes 464 and 468.

Therefore, when a voltage is applied to each of the first to sixth semiconductor light-emitting elements 421 to 426, light having a wavelength band corresponding to the current according to the voltage may be emitted from each of the first to sixth semiconductor light-emitting elements 421 to 426.

For example, when a first voltage is applied to the first semiconductor light-emitting element 421, a first current flows in the order of the first connection line 370-1, the first contact hole 461, the first semiconductor light-emitting element 421, the common connection electrode 450, the first assembling wiring 441, the first common pad 443, the fourth contact hole 464, and the fourth connection line 370-4, so that first light having a wavelength band corresponding to the first current may be emitted.

For example, when a second voltage is applied to the second semiconductor light-emitting element 422, a second current flows in the order of the second connection line 370-2, the second contact hole 462, the second semiconductor light-emitting element 422, the common connection electrode 450, the first assembling wiring 441, the first common pad 443, the fourth contact hole 464, and the fourth connection line 370-4, so that second light having a wavelength band corresponding to the second current may be emitted.

For example, when a third voltage is applied to the third semiconductor light-emitting element 423, a third current flows in the order of the third connection line 370-3, the third contact hole 463, the third semiconductor light-emitting element 423, the common connection electrode 450, the first assembling wiring 441, the first common pad 443, the fourth contact hole 464, and the fourth connection line 370-4, so that a third light having a wavelength band corresponding to the third current may be emitted.

For example, the first light may be red light, the second light may be green light, and the third light may be blue light, but are not limited thereto.

The plurality of semiconductor light-emitting element packages 350 described above may be assembled on the display substrate 310 illustrated in FIGS. 7 and 8 using a self-assembly process, and a post-process for electrical connection may be performed, so that the display device 300 may be manufactured.

The above describes in detail a semiconductor light-emitting element package 350 comprising the semiconductor light-emitting elements 422, 423, 425, and 426 self-assembled on a pair of assembling wirings 441 and 442, and the semiconductor light-emitting elements 421 and 424 formed in an epitaxial layer 1005 on each side of a pair of assembling wirings 441 and 442.

Alternatively, a semiconductor light-emitting element package may be manufactured comprising the semiconductor light-emitting elements self-assembled on each of a pair of first assembling wirings and a pair of second assembling wirings, and semiconductor light-emitting elements formed in an epitaxial layer 1005 between the first assembling wirings and the second assembling wirings.

### [Second Embodiment]

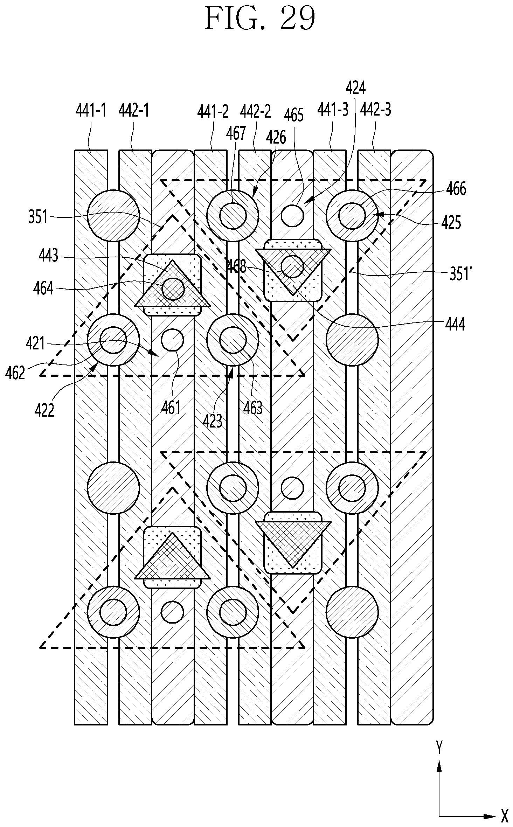

Hereinafter, a semiconductor light-emitting element package according to a second embodiment is described with reference to FIG. 29.

FIG. 29 is a plan view illustrating a plurality of semiconductor light-emitting element packages according to the second embodiment manufactured on a wafer.

As illustrated in FIG. 29, a plurality of pairs of assembling wirings 441-1 to 441-3 and 442-1 to 442-3 may be formed on a wafer (1000 of FIGS. 16A to 16E). The plurality of pairs of assembling wirings 441-1 to 441-3 and 442-1 to 442-3 may be formed in pre-formed recesses 1010, which may be easily understood from the first embodiment described above (FIGS. 16A to 16E), and therefore, a detailed description thereof is omitted.

Semiconductor light-emitting elements 422, 423, 425, and 426 emitting different light may be formed on each of the plurality of pairs of assembling wirings 441-1 to 441-3 and 442-1 to 442-3.

For example, a plurality of semiconductor light-emitting elements 422 for emitting second light may be formed on a pair of first assembling wirings 441-1 and 442-1, a plurality of semiconductor light-emitting elements 423 and 426 for emitting third light may be formed on a pair of second assembling wirings 441-2 and 442-2, and a plurality of semiconductor light-emitting elements 425 for emitting second light may be formed on a pair of third assembling wirings 441-3 and 442-3. In this way, a plurality of semiconductor light-emitting elements 422 and 425 for emitting the second light and a plurality of semiconductor light-emitting elements 423 and 426 for emitting the third light may be alternately formed in each pair of assembling wirings 441-1 to 441-3 and 442-1 to 442-3.

Meanwhile, a plurality of semiconductor light-emitting elements 421 and 424 for emitting first light may be formed from an epilayer 1005 between adjacent pairs of assembling wirings 441-1 to 441-3 and 442-1 to 442-3. For example, a plurality of semiconductor light-emitting elements 421 and 424 for emitting the first light may be formed in each of the epitaxial layer 1005 between a pair of first assembling wirings 441-1 and 442-1 and a pair of second assembling wirings 441-2 and 442-2 and an epitaxial layer 1005 between a pair of second assembling wirings 441-2 and 442-2 and a pair of third assembling wirings 441-3 and 442-3.

The semiconductor light-emitting elements 421 and 424 for emitting the first light may be first semiconductor light-emitting elements, the plurality of semiconductor light-emitting elements 422 and 425 for emitting the second light may be second semiconductor light-emitting elements, and the plurality of semiconductor light-emitting elements 423 and 426 for emitting the third light may be third semiconductor light-emitting elements.

Meanwhile, common pads 443 and 444 may be formed on one side of the first semiconductor light-emitting elements 421 and 424.

The common pads 443 and 444 may extend to both sides and be connected to a pair of assembling wirings 441-1 to 441-3 and 442-1 to 442-3. For example, a first side of the first common pad 443 may be connected to a first assembling wiring 442-1 among a pair of first assembling wirings 441-1 and 442-1, and a second side of the first common pad 443 may be connected to a second assembling wiring 441-2 among a pair of second assembling wirings 441-2 and 442-2. For example, a first side of the second common pad 444 may be connected to a second assembling wiring 442-2 among the pair of second assembling wirings 441-2 and 442-2, and a second side of the second common pad 444 may be connected to a third assembling wiring 441-3 among the pair of third assembling wirings 441-3 and 442-3.

Meanwhile, although not illustrated, a plurality of first to sixth semiconductor light-emitting elements 421 to 426 may be commonly connected by a common connection electrode 450. The common connection electrode 450 may be easily understood from the first embodiment described above (FIGS. 16A to 16E), and thus a detailed description thereof will be omitted.

Meanwhile, as illustrated in FIG. 29, semiconductor light-emitting element packages 351 and 351' comprising the first semiconductor light-emitting elements 421 and 424, the second semiconductor light-emitting elements 422 and 425, and the third semiconductor light-emitting elements 423 and 426 may be obtained. In this instance, the semiconductor light-emitting element packages 351 and 351' may be triangular when viewed from above. Accordingly, a plurality of package regions 350a having a triangular shape may be separated on the wafer 1000, and the common connection electrode 450 may be formed on a lower side of each of the separated plurality of package regions 350a, thereby manufacturing a plurality of semiconductor light-emitting element packages 351 and 351'.

For example, a first semiconductor light-emitting element package 351 may be obtained by the first semiconductor light-emitting element 421, the second semiconductor light-emitting element 422, and the third semiconductor light-emitting element 423, and a second semiconductor light-emitting element package 351' may be obtained by the first semiconductor light-emitting element 424, the second semiconductor light-emitting element 425, and the third semiconductor light-emitting element 426.

Meanwhile, although not illustrated, one semiconductor light-emitting element package may be obtained by six semiconductor light-emitting elements 421 to 426. The semiconductor light emitting device package may be, but is not limited thereto, a parallelogram when viewed from above.

In this instance, as illustrated in FIG. 13, the semiconductor light-emitting element package may comprise two pixels PX1 and PX2. That is, the first pixel PX1 may be configured by the first to third semiconductor light-emitting elements 421 to 423, and the second pixel PX2 may be configured by the fourth to sixth semiconductor light-emitting elements 424 to 426. Accordingly, when the semiconductor light-emitting element package is disposed in the assembly hole 340H of FIG. 7, the number of pixels can be doubled by comprising two pixels PX1 and PX2 per pixel PX, so that an ultra-high-resolution display can be implemented.

In addition, as illustrated in FIG. 14, the semiconductor light-emitting element package may comprise the pixel PX1 and the dummy pixel PX_D. That is, the pixel PX1 may be configured by the first to third semiconductor light-emitting elements 421 to 423, and the dummy pixel PX_D may be configured by the fourth to sixth semiconductor light-emitting elements 424 to 426. Therefore, when the semiconductor light-emitting element package 350 is disposed in the assembly hole 340H illustrated in FIG. 7, the pixel PX may display an image and the dummy pixel PX_D does not display an image.

When a specific semiconductor light-emitting element of the corresponding pixel PX1 breaks down, a semiconductor light-emitting element that emits light of the same color as light emitted from the specific semiconductor light-emitting element may be selected from the dummy pixel PX_D, and the specific semiconductor light-emitting element that broke down in the corresponding pixel PX1 may be replaced by the semiconductor light-emitting element selected from the dummy pixel PX_D. Accordingly, a desired color image can always be displayed regardless of a breakdown of the semiconductor light-emitting element in the pixel PX1.

Meanwhile, the display device described above may be a display panel. That is, in the embodiment, the display device and the display panel may be understood to have the same meaning. In the embodiment, the display device in a practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a micro-level semiconductor light-emitting element or a nano-level semiconductor light-emitting element.

For example, the embodiment may be adopted in a TV, signage, a smart phone, a mobile phone, a mobile terminal, a HUD for an automobile, a backlight unit for a laptop computer, and a display device for VR or AR.

## Claims

1. A semiconductor light-emitting element package, comprising:
a common connection electrode having a first region and a second region;
a first semiconductor light-emitting element on the first region of the common connection electrode;
a pair of first assembling wirings on the second region of the common connection electrode; and
a second semiconductor light-emitting element on the pair of first assembling wirings.

2. The semiconductor light-emitting element package of claim 1, comprising:
a third semiconductor light-emitting element on the pair of first assembling wirings.

3. The semiconductor light-emitting element package of claim 2, wherein the common connection electrode has a third region,
wherein the second region is positioned between the first region and the third region,
comprising:
a fourth semiconductor light-emitting element on the third region of the common connection electrode; and
a fifth semiconductor light-emitting element and a sixth semiconductor light-emitting element on the pair of first assembling wirings.

4. The semiconductor light-emitting element package of claim 3, wherein the first semiconductor light-emitting element and the fourth semiconductor light-emitting element are red semiconductor light-emitting elements,
wherein the second semiconductor light-emitting element and the fifth semiconductor light-emitting element are green semiconductor light-emitting elements, and
wherein the third semiconductor light-emitting element and the sixth semiconductor light-emitting element are blue semiconductor light-emitting elements.

5. The semiconductor light-emitting element package of claim 4, wherein the first semiconductor light-emitting element, the second semiconductor light-emitting element, and the third semiconductor light-emitting element constitute a first pixel, and
wherein the fourth semiconductor light-emitting element, the fifth semiconductor light-emitting element, and the sixth semiconductor light-emitting element constitute a second pixel.

6. The semiconductor light-emitting element package of claim 4, wherein the first semiconductor light-emitting element, the second semiconductor light-emitting element, and the third semiconductor light-emitting element constitute a pixel, and
wherein the fourth semiconductor light-emitting element, the fifth semiconductor light-emitting element, and the sixth semiconductor light-emitting element constitute a dummy pixel.

7. The semiconductor light-emitting element package of claim 4, wherein the second semiconductor light-emitting element, the third semiconductor light-emitting element, the fifth semiconductor light-emitting element, and the sixth semiconductor light-emitting element are disposed between the first semiconductor light-emitting element and the fourth semiconductor light-emitting element.

8. The semiconductor light-emitting element package of claim 4, wherein the third semiconductor light-emitting element and the sixth semiconductor light-emitting element are disposed between the second semiconductor light-emitting element and the fifth semiconductor light-emitting element.

9. The semiconductor light-emitting element package of claim 3, wherein the common connection electrode is connected to a lower side of each of the first semiconductor light-emitting element and the fourth semiconductor light-emitting element, and is connected to a lower side of each of the second semiconductor light-emitting element, the third semiconductor light-emitting element, the fifth semiconductor light-emitting element, and the sixth semiconductor light-emitting element between the pair of first assembling wirings.

10. The semiconductor light-emitting element package of claim 9, wherein the common connection electrode is connected to a lower side of each of the pair of first assembling wirings.

11. The semiconductor light-emitting element package of claim 3, comprising:
a first common pad on one side of the first semiconductor light-emitting element; and
a second common pad on one side of the fourth semiconductor light-emitting element.

12. The semiconductor light-emitting element package of claim 11, wherein the first common pad is connected to a first assembling wiring of the pair of first assembling wirings, and
wherein the second common pad is connected to a second assembling wiring of the pair of first assembling wirings.

13. The semiconductor light-emitting element package of claim 11, wherein the first common pad and the second common pad are positioned diagonally.

14. The semiconductor light-emitting element package of claim 3, wherein the first semiconductor light-emitting element and the fourth semiconductor light-emitting element comprise a GaAs-based semiconductor material, and
wherein the second semiconductor light-emitting element, the third semiconductor light-emitting element, the fifth semiconductor light-emitting element, and the sixth semiconductor light-emitting element each comprise a GaN-based semiconductor material.

15. The semiconductor light-emitting element package of claim 3, wherein each of the second semiconductor light-emitting element, the third semiconductor light-emitting element, the fifth semiconductor light-emitting element, and the sixth semiconductor light-emitting element comprises a magnetic layer.

16. The semiconductor light-emitting element package of claim 1, wherein the common connection electrode comprises a reflective layer.

17. The semiconductor light-emitting element package of claim 1, wherein the common connection electrode has a third region, and
wherein the first region is positioned between the second region and the third region,
comprising:
a pair of second assembling wirings on the third region of the common connection electrode; and
a third semiconductor light-emitting element on the pair of second assembling wirings.

18. The semiconductor light-emitting element package of claim 17, wherein at least one of the common connection electrode, the pair of first assembling wirings, or the pair of second assembling wirings comprises a magnetic layer.

19. A display device, comprising:
a panel substrate comprising a plurality of pixels;
a pair of first assembling wirings corresponding to each of the plurality of pixels;
a partition wall comprising an assembly hole on the pair of first assembling wirings; and
a semiconductor light-emitting element package in the assembly hole,
wherein the semiconductor light-emitting element package comprises:
a common connection electrode having a first region and a second region;
a first semiconductor light-emitting element on the first region of the common connection electrode;
a pair of second assembly wirings on the second region of the common connection electrode; and
a second semiconductor light-emitting element and a third semiconductor light-emitting element on the pair of second assembly wirings.
